# EUROPEAN PATENT APPLICATION

(11) **EP 2 750 191 A1**
(43) Date of publication of application: **02.07.2014**
(21) Application number: 14161265.5
(22) Date of filing: 12.03.2008
(51) Int. Cl.: H01L 27/146, C09B 57/00, H01L 51/44, H01L 27/30, G03G 5/06

(54) **Photoelectric conversion element and solid-state imaging device**

(30) Priority: 12.03.2007 JP 2007062234; 28.03.2007 JP 2007084981
(62) Divisional of application: 08004573.5
(71) Applicant: Fujifilm Corporation, Minato-ku Tokyo (JP)
(72) Inventor: Mitsui, Tetsuro, Kanagawa (JP); Kitamura, Tetsu, Kanagawa (JP); Nomura, Kimiatsu, Kanagawa (JP); Harada, Toru, Kanagawa (JP)
(74) Representative: HOFFMANN EITLE

(57) **Abstract**

A photoelectric conversion element comprises a first photoelectric conversion part, the first photoelectric conversion part comprising: a pair of electrodes (11, 13); and a photoelectric conversion film (12) between the pair of electrodes (11,13), wherein the photoelectric conversion film comprises an organic photoelectric conversion material having an absorption peak in an infrared region of an absorption spectrum within a combined range of a visible region and the infrared region and generating an electric charge according to light absorbed, and the first photoelectric conversion part as a whole transmits 50% or more of light in the visible region.

## Description

### Background of the Invention

### 1. Field of the Invention

The present invention relates to a photoelectric conversion element comprising a photoelectric conversion part containing a pair of electrodes and a photoelectric conversion film provided between the pair of electrodes.

The present invention relates to a photoelectric conversion element comprising a photoelectric conversion part containing a pair of electrodes and an infrared organic photoelectric conversion film provided between the pair of electrodes.

### 2 Description of the Related Art

The related-art visible light sensors in general are produced by forming a photoelectric conversion element through formation of PN junction in a semiconductor such as Si. As for the solid-state imaging device, there is widely known a flat-type image-receiving device where photoelectric conversion elements are two-dimensionally arrayed in a semiconductor and a signal generated resulting from photoelectric conversion is read out by each photoelectric conversion element according to a CCD or CMOS format. The method for realizing a color solid-state imaging device is generally a structure where the flat-type image-receiving device is disposed on the light incident surface side and a color filter transmitting only light at a specific wavelength is disposed for color separation. Particularly, a single-plate sensor in which color filters transmitting blue light, green light and red light are regularly disposed on respective two-dimensionally arrayed photoelectric conversion elements is well known as a system widely used at present in a digital camera and the like.

The sensor sensitive to infrared light generally uses a heat-type sensor (e.g., thermal electromotive force type, current collection effect, thermocouple effect) or a quantum-type sensor (e.g., photovoltaic effect, photoconductive effect, photoemission effect). Most of these sensors are composed of an inorganic semiconductor, and the inorganic semiconductor has a property of broadly absorbing light at a wavelength shorter than a given wavelength and therefore, absorbing light in the entire region from the light in the infrared region to the light in the visible region.

In the case of simultaneously obtaining an image of visible light and an image of infrared light, there may be considered a method of separating the incident light into infrared light and visible light and detecting these lights by different devices, or a method of two-dimensionally disposing color filters transmitting visible light and infrared light, respectively, on one device. According to such a method, an image of visible light and an image of infrared light may be obtained at the same time, but these methods have problems, for example, that the size of the device or apparatus becomes large and the cost rises; the image is not sampled at the same point and the synthesis, processing and the like of image information are difficult; or the color filter transmits only light at a limited wavelength and the non-transmitted light is not utilized, giving rise to bad light utilization efficiency.

In order to overcome these problems, a method of stacking a photoelectric conversion part capable of detecting lights at different wavelengths may be considered. As regards such a system, in so far as visible light is concerned, for example, U.S. Patent 5,965,875 discloses a sensor in which a vertical stack structure is formed in a silicon substrate to utilize the wavelength dependency of absorption coefficient of Si and the color is separated by the difference among respective depths, and JP-A-2003-332551 discloses a sensor having a structure where an organic photoelectric conversion film is stacked on the upper side of a silicon substrate.

The system of stacking a photoelectric conversion part for detecting infrared light and a photoelectric conversion part for detecting visible light in the vertical direction is disadvantageous not only in that the absorption ranges are overlapped in respective portions in the depth direction of the silicone substrate and the color separation is originally poor due to bad spectral characteristics, but also in that when using Si, although a photoelectric conversion part for detecting infrared light must be further provided as the lowermost layer of the silicon substrate in the sensor of U.S. Patent 5,965,875, infrared light is absorbed in the upper layer to reduce the infrared light reaching the lowermost layer in the silicon substrate and the sensitivity decreases.

As described above, when an inorganic semiconductor is used, it is difficult for the inorganic semiconductor alone to absorb only infrared light, but an organic film can be designed to absorb only light in a specific wavelength region and therefore, can be used as a layer absorbing only infrared light. For example, the organic film is used as an infrared cut filter in a flat panel display and the like. As regards the infrared organic photoelectric conversion thin film transmitting a part of visible light, for example, JP-A-63-186251 discloses an organic photoelectric conversion film using a metal phthalocyanine derivative and selectively absorbing light at 600 to 800 nm. However, in JP-A-63-186251, an upper A1 electrode is used, which is insufficient in the transparency to visible light, and the contents disclosed therein are inadequate for imaging by visible light and infrared light. In the electrophotographic technology, it is known that titanyl phthalocyanine and the like are widely used as an organic material sensitive to infrared light, but such a material has large absorption at a wavelength around 600 nm and is insufficient in the transparency to visible light. Furthermore, the image-forming system using the existing structure and electric charging for the electrophotographic device is unsuited for a small imaging system without a light source, such as digital still camera, and can be hardly applied to a system of simultaneously taking the images of visible light and infrared light. Incidentally, JP-A-2003-332551 discloses a structure related to visible light and is silent on a structure including infrared light.

The method of forming the organic film includes, for example, a coating method such as spin coating, and a vapor deposition method of vaporizing a material under heating in vacuum and depositing it on a base, and for preventing intermingling of impurities and enabling wide latitude in forming multiple layers so as to achieve a higher function, a vapor deposition method is preferred. In this case, for example, a chroconium or merocyanine-based coloring matter representative of a coloring matter having absorption in the infrared region has a low decomposition temperature and readily decomposes during heating at the vapor deposition and a film can be hardly formed. As for the related-art material which has absorption in the infrared region and can be vapor-deposited and which is proved to exhibit a high photoelectric conversion function in an electrophotographic device, an organic thin-film solar cell and the like, a phthalocyanine-based coloring matter is reported in JP-A-63-186251. However, according to the studies by the present inventors, this material has a drawback that the current at the dark time (dark current) giving rise to a noise generally tends to become large in an imaging device and a high S/N can be hardly obtained.

Other than these materials, a squarylium-based coloring matter is known in Applied Physics Letters, 29, 414 (1976) as a material which can be vapor-deposited and exhibits a significant photoelectric conversion function. As for the squarylium-based coloring matter, generally, many materials readily decompose at the vapor deposition, and a structure for enhancing the vapor deposition property by raising the decomposition temperature and lowering the vapor deposition temperature is reported in J. Phys. Chem. B, 106, 4370 (2002). In J. Phys. Chem. B, 106, 4370 (2002), Compound 5 described later is disclosed and a bulky substituent which is less decomposable is imparted, so that the vapor deposition can be facilitated by suppressing the intermolecular interaction and the vapor deposition property can be enhanced by inhibiting the decomposition. However, when the present inventors studied on the photoelectric conversion performance of such a material, the photoelectric conversion performance was conspicuously low. In this way, when the vapor deposition property is enhanced by providing a substituent working out to a steric hindrance, it is presumed that the signal electric charge transport property tends to deteriorate due to low intermolecular interaction.

### Summary of the Invention

A first object of the present invention is to provide a photoelectric conversion element most suitable for a solid-state imaging device capable of simultaneously performing the photographing of a visible image based on visible light reflected from a photographic subject and the photographing of an infrared image based on infrared light.

The photoelectric conversion element of the first invention is a photoelectric conversion element comprising a first photoelectric conversion part, the first photoelectric conversion part comprising: a pair of electrodes; and a photoelectric conversion film between the pair of electrodes, wherein the photoelectric conversion film comprises an organic photoelectric conversion material having an absorption peak in an infrared region of an absorption spectrum within a combined range of a visible region and the infrared region and generating an electric charge according to light absorbed, and the first photoelectric conversion part as a whole transmits 50% or more of light in the visible region.

In the photoelectric conversion element of the present invention, an absorptance at the absorption peak of the organic photoelectric conversion material is 50% or more.

In the photoelectric conversion element of the present invention, a transmittance of light in the visible region in the first photoelectric conversion part is 75% or more.

In the photoelectric conversion element of the present invention, a transmittance of light in the visible and infrared regions of one, on a light incident side, of the pair of electrodes is 95% or more.

In the photoelectric conversion element of the present invention, a transmittance of light in the visible region of one, on a side opposite to a light incident side, of the pair of electrodes is 95% or more.

In the photoelectric conversion element of the present invention, the pair of electrodes each comprises TCO.

In the photoelectric conversion element of the present invention, the TCO is ITO, and the organic photoelectric conversion material is tin phthalocyanine.

In the photoelectric conversion element of the present invention, the organic photoelectric conversion material comprises phthalocyanine, naphthalocyanine or squarylium.

In the photoelectric conversion element of the present invention, the phthalocyanine and the naphthalocyanine each has an axial ligand.

In the photoelectric conversion element of the present invention, the photoelectric conversion element further comprises: a semiconductor substrate, the first photoelectric conversion part being above the semiconductor substrate; and at least one visible light photoelectric conversion part having an absorption peak in the visible region of an absorption spectrum within the combined range of the visible region and the infrared region and generating an electric charge according to light absorbed, said at least one visible light photoelectric conversion part being between the semiconductor substrate and the first photoelectric conversion part.

In the photoelectric conversion element of the present invention, the semiconductor substrate comprises: an accumulation part that accumulates an electric charge generated in each of the first photoelectric conversion part and said at least one visible light photoelectric conversion part; and a signal read-out part that reads out a signal according to the electric charge accumulated in the accumulation part.

In the photoelectric conversion element of the present invention, the photoelectric conversion element further comprises: a semiconductor substrate, the first photoelectric conversion part being above the semiconductor substrate; and at least one visible light photoelectric conversion part having an absorption peak in the visible region of an absorption spectrum within the combined range of the visible region and the infrared region and generating an electric charge according to light absorbed, said at least one visible light photoelectric conversion part being in the semiconductor substrate.

In the photoelectric conversion element of the present invention, the semiconductor substrate comprises: an accumulation part that accumulates an electric charge generated in the first photoelectric conversion part; and a signal read-out part that reads out a signal according to the electric charge accumulated in the accumulation part.

In the photoelectric conversion element of the present invention, said at least one visible light photoelectric conversion part comprises a plurality of visible light photoelectric conversion parts, and said plurality of visible light photoelectric conversion parts have an absorption peak at wavelengths different from each other.

In the photoelectric conversion element of the present invention, said plurality of visible light photoelectric conversion parts are stacked in a light incident direction to the first photoelectric conversion part.

In the photoelectric conversion element of the present invention, said at least one visible light photoelectric conversion part comprises a plurality of visible light photoelectric conversion parts, and said plurality of visible light absorption parts have an absorption peak at wavelengths different from each other and are arrayed in a vertical direction with respect to a light incident direction to the first photoelectric conversion part.

In the photoelectric conversion element of the present invention, said at least one visible light photoelectric conversion part comprises three visible light photoelectric conversion parts, and the three visible light photoelectric conversion parts are an R photoelectric conversion part that absorbs light in a red wavelength region, a G photoelectric conversion part that absorbs light in a green wavelength region, and a B photoelectric conversion part that absorbs light in a blue wavelength region.

In the photoelectric conversion element of the present invention, the first photoelectric conversion part and said at least one visible light photoelectric conversion part are overlapped as viewed in plane such that light transmitted through the first photoelectric conversion part enters said at least one visible light photoelectric conversion part.

The solid-state imaging device of the present invention comprises photoelectric conversion elements disposed on the same plane in an array manner, wherein each of the photoelectric conversion elements is any one of the photoelectric conversion elements above.

According to the first invention, a photoelectric conversion element most suitable for a solid-state imaging device capable of simultaneously performing the photographing of a visible image based on visible light reflected from a photographic subject and the photographing of an infrared image based on infrared light can be provided.

An second object of the present invention is to provide a squarylium-based coloring matter with excellent vapor deposition property for use in a photoelectric conversion element suitable for photographing an infrared image based on infrared light, and a photoelectric conversion element using the squarylium-based coloring matter, which is most suitable for a solid-state imaging device capable of simultaneously performing the photographing of a visible image based on visible light reflected from a photographic subject and the photographing of an infrared image based on infrared light.

The photoelectric conversion element of the second invention is a photoelectric conversion element comprising a photoelectric conversion part containing a pair of electrodes and a photoelectric conversion film provided between the pair of electrode, wherein the photoelectric conversion film comprises a squarylium-based coloring matter with excellent vapor deposition property. Furthermore, the photoelectric conversion film comprises an organic photoelectric conversion material having an absorption peak in the infrared region of an absorption spectrum in the combined range of a visible region and an infrared region and generating an electric charge according to the light absorbed, and the photoelectric conversion material contains a squarylium-based coloring matter. Specifically, the present invention is achieved by the following means.
(1) A photoelectric conversion element comprising a first photoelectric conversion part, the first photoelectric conversion part comprising: a pair of electrodes; and a photoelectric conversion film between the pair of electrodes, wherein the photoelectric conversion film comprises an organic photoelectric conversion material, and the organic photoelectric conversion material comprises a compound represented by formula (SQ-1): 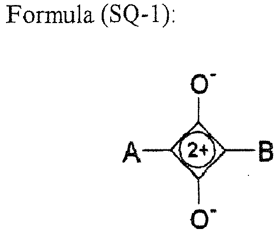 (wherein A and B each independently represents a substituent with the bonding site being an SP² carbon).
(2) The photoelectric conversion element as described in (1), wherein formula (SQ-1) is represented by formula (SQ-2): 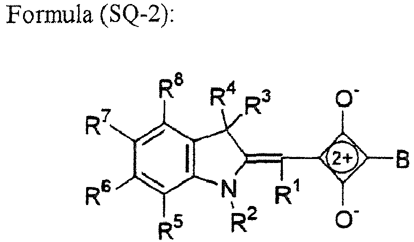 (wherein R¹ to R⁸ each independently represents a hydrogen atom or a substituent, a plurality of R¹ to R⁸ may combine to form a ring, and B has the same meaning as in formula (SQ-1)).
(3) The photoelectric conversion element as described in (1) or (2), wherein formula (SQ-2) is represented by formula (SQ-3): 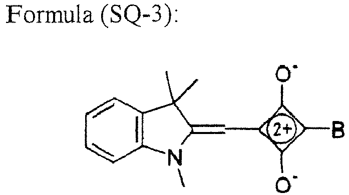 (wherein B has the same meaning as in formula (SQ-2)).
(4) The photoelectric conversion element as described in any one of (1) to (3), wherein B is represented by the same structure as A or a portion corresponding to A, and the compound has a decomposition temperature of 200°C or more.
(5) The photoelectric conversion element as claimed in any one of (1) to (4), wherein the organic photoelectric conversion material has an absorption peak in an infrared region of an absorption spectrum within a combined range of a visible region and the infrared region and generating an electric charge according to light absorbed, and the first photoelectric conversion part as a whole transmits 50% or more of light in the visible region at 400 to 600 nm.
(6) The photoelectric conversion element as described in (5), wherein an absorption peak wavelength of the photoelectric conversion film is 650 nm or more (preferably 700 nm or more) and the first photoelectric conversion part as a whole transmits 75% or more of visible light.
(7) The photoelectric conversion element as described in (5) or (6), wherein an absorptance at the absorption peak wavelength of the photoelectric conversion film is 50% or more.
(8) The photoelectric conversion element as described in any one of (5) to (7), wherein a transmittance of light in the visible and infrared regions of one, on the light incident side, of the pair of electrodes is 95% or more.
(9) The photoelectric conversion element as described in any one of (5) to (8), wherein a transmittance of light in the visible region of one, on a side opposite to a light incident side, of the pair of electrodes is 95% or more.
(10) The photoelectric conversion element as described in any one of (5) to (9), wherein the pair of electrodes each comprises TCO.
(11) The photoelectric conversion element as described in any one of (5) to (10), wherein the TCO is ITO.
(12) The photoelectric conversion element as described in any one of (5) to (11), further comprising: a semiconductor substrate, the first photoelectric conversion part being above the semiconductor substrate; and at least one visible light photoelectric conversion part having an absorption peak in the visible region of an absorption spectrum within the combined range of the visible region and the infrared region and generating an electric charge according to light absorbed, said at least one visible light photoelectric conversion part being between the semiconductor substrate and the first photoelectric conversion part.
(13) The photoelectric conversion element as described in (12), wherein the semiconductor substrate comprises: an accumulation part that accumulates an electric charge generated in each of the first photoelectric conversion part and said at least visible light photoelectric conversion part; and a signal read-out part that reads out a signal according to the electric charge accumulated in the accumulation part.
(14) The photoelectric conversion element as described in any one of (5) to (13), further comprising: a semiconductor substrate, the first photoelectric conversion part being above the semiconductor substrate; and at least one visible light photoelectric conversion part having an absorption peak in the visible region of an absorption spectrum within the combined range of the visible region and the infrared region and generating an electric charge according to the light absorbed, said at least one visible light photoelectric conversion part being in the semiconductor substrate.
(15) The photoelectric conversion element as described in (14), wherein the semiconductor substrate comprises: an accumulation part that accumulates an electric charge generated in the first photoelectric conversion part; and a signal read-out part that reads out a signal according to the electric charge accumulated in the accumulation part.
(16) The photoelectric conversion element as described in any one of (12) to (15), wherein said at least one visible light photoelectric conversion part comprises a plurality of visible light photoelectric conversion parts, and said plurality of visible light photoelectric conversion parts have an absorption peak at wavelengths different from each other.
(17) The photoelectric conversion element as described in (16), wherein said plurality of visible light photoelectric conversion parts are stacked in a light incident direction to the first photoelectric conversion part.
(18) The photoelectric conversion element as described in (15), wherein said at least one visible light photoelectric conversion part comprises a plurality of visible light photoelectric conversion parts, and said plurality of visible light absorption parts have an absorption peak at wavelengths different from each other and are arrayed in a vertical direction with respect to a light incident direction to the first photoelectric conversion part.
(19) The photoelectric conversion element as described in (12), wherein said at least one visible light photoelectric conversion part comprises three visible light photoelectric conversion parts, and the three visible light photoelectric conversion parts are an R photoelectric conversion part that absorbs light in a red wavelength region, a G photoelectric conversion part that absorbs light in a green wavelength region, and a B photoelectric conversion part that absorbs light in a blue wavelength region.
(20) The photoelectric conversion element as described in any one of (1) to (19), wherein the first photoelectric conversion part and said at least one visible light photoelectric conversion part are overlapped as viewed in plane such that light transmitted through the first photoelectric conversion part enters said at least one visible light photoelectric conversion part.
(21) The photoelectric conversion element as described in any one of (1) to (20), wherein the photoelectric conversion film comprises a hole blocking layer and an electron blocking layer.
(22) A solid-state imaging device comprising photoelectric conversion elements disposed on the same plane in an array manner, wherein each of the photoelectric conversion elements is the photoelectric conversion element described in any one of (1) to (21).
(23) A squarylium compound represented by formula (SQ-3): 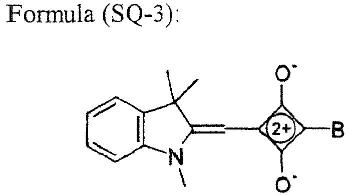 (wherein B represents a substituent with a bonding site being an sp² carbon and B comprises a quinoline nucleus, a pyrylium nucleus, a thiopyrylium nucleus, an azulene nucleus or a dihydroperimidine nucleus).

According to the second invention, a photoelectric conversion element containing a squarylium-based coloring matter and ensuring high photoelectric conversion efficiency and low noise as well as good vapor deposition property can be provided. Also, a photoelectric conversion element most suitable for a solid-state imaging device capable of simultaneously performing the photographing of a visible image based on visible light reflected from a photographic subject structure and the photographing of an infrared image based on infrared light can be provided.

### Brief Description of the Drawings

Fig. 1 is a cross-sectional schematic view roughly showing the construction of the photoelectric conversion element in the first embodiment of the present invention;
Figs. 2A to 2D are cross-sectional schematic views roughly showing the construction of the photoelectric conversion element in the second embodiment of the present invention;
Fig. 3 is a cross-sectional schematic view showing a preferred embodiment of the photoelectric conversion element in the first embodiment of the present invention;
Fig. 4 is a partial surface schematic view of the imaging device for explaining the embodiment of the present invention;
Fig. 5 is a cross-sectional schematic view cut along the A-A line of the imaging device shown in Fig. 4;
Fig. 6 is a view showing a specific construction example of the signal read-out part shown in Fig. 5;
Fig. 7 is a view showing the absorption spectrum of the element of Example 1;
Fig. 8 is a view showing the absorption spectrum of the element of Example 2-3;
Fig. 9 is a view showing the absorption spectrum of the element of Example 2-4;
Fig. 10 is a view showing the absorption spectrum of the element of Reference Example 1;
Fig. 11 is a view showing the absorption spectrum of the element of Comparative Example 1; and
Fig. 12 is a view showing the absorption spectrum of the element of Comparative Example 2.

### Detailed Description of the Invention

The embodiments of the present invention are described below by referring to the drawings. In the following, the light (R light) in the red (R) wavelength region indicates light at a wavelength of generally from 550 to 650 nm, the light (G light) in the green (G) wavelength region indicates light at a wavelength of generally from 450 to 610 nm, the light (B light) in the blue (B) wavelength region indicates light at a wavelength of generally from 400 to 520 nm, the light (infrared light) in the infrared wavelength region indicates light at a wavelength of generally from 680 to 10,000 nm, and the light (visible light) in the visible wavelength region indicates light at a wavelength of generally from 400 to 650 nm. Also, "the absorptance or transmittance in a certain wavelength region of α to β nm" as used in the context of the present invention can be expressed by Y/X×100 wherein assuming that the absorptance or transmittance in the wavelength region of α to β nm is 100%, X is the integration value in the wavelength region of α to β nm and Y is the integration value in the wavelength region of α to β nm of the absorptance or transmittance at each wavelength.

### (First Embodiment)

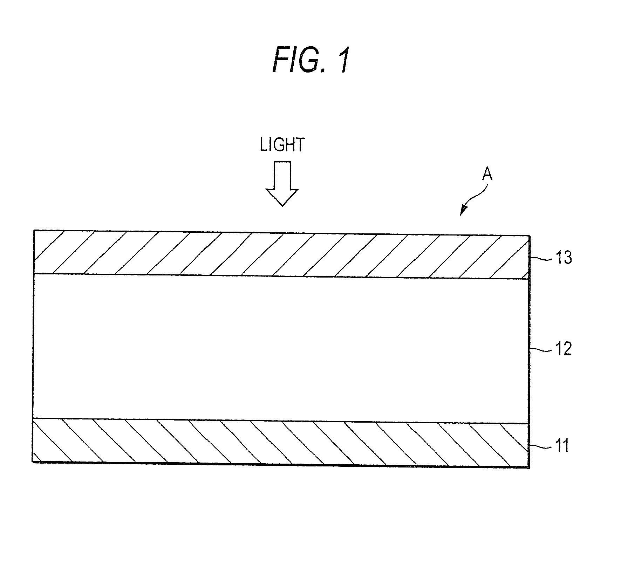

Fig. 1 is a cross-sectional schematic view roughly showing the construction of the photoelectric conversion element in the first embodiment of the present invention.

The photoelectric conversion element shown in Fig. 1 comprises at least a photoelectric conversion part A containing a lower electrode 11, an upper electrode 13 facing the lower electrode 11, and a photoelectric conversion film 12 provided between the lower electrode 11 and the upper electrode 13. The photoelectric conversion element shown in Fig. 1 is used by making light incident from the upper side of the upper electrode 13.

The upper electrode 13 is a transparent electrode composed of an electrically conductive material transparent to light (visible light and infrared light) in the combined range of a visible region and an infrared region (the range at a wavelength of 400 nm or more). The expression "transparent to light at a certain wavelength" as used in the present invention means that 70% or more of light at the wavelength is transmitted. A bias voltage is applied to the upper electrode 13 through wiring not shown. The polarity of this bias voltage is determined such that out of electric charges generated in the photoelectric conversion film 12, an electron moves to the upper electrode 13 and a hole moves to the lower electrode 11. Of course, the bias voltage may be set such that out of electric charges generated in the photoelectric conversion film 12, a hole moves to the upper electrode 13 and an electron moves to the upper electrode 11. As for the bias voltage, the value obtained by dividing the bias voltage value by the distance between the lower electrode 11 and the upper electrode 13 is preferably from 1.0×10⁵ to 1.0×10⁷ V/cm, more preferably from 1.0×10⁴ to 1.0x10⁶ V/cm. With the bias voltage in this range, an electron can be efficiently moved to the upper electrode 13, and a signal according to the electron can be taken outside.

For the application to a solid-state imaging device capable of simultaneously performing the photographing of a visible image and the photographing of an infrared image (hereinafter referred to as a "visible•infrared imaging device"), similarly to the upper electrode 11, a transparent electrode is preferably used for the lower electrode 11, because out of the incident light, visible light must be transmitted to the lower side thereof. However, the lower electrode 11 need not be transparent to light in the infrared region and may be sufficient if it is transparent at least to light in the visible region.

The photoelectric conversion film 12 is a film comprising an organic photoelectric conversion material having an absorption peak in the infrared region of an absorption spectrum in the combined range of a visible region and an infrared region (light at a wavelength of 400 nm or more) and generating an electric charge according to the light absorbed.

In the first invention, examples of the organic photoelectric conversion material include a cyanine dye, a squarylium dye, a chroconium dye, an azamethine dye, a polymethine dye, an azulenium dye, a pyrylium dye, a phthalocyanine dye, a metal complex dye, a quinone dye, an aminium dye, an immonium dye and an indigo dye. Among these, a squarylium dye and a phthalocyanine dye are preferred.

In the first invention, in the case of film-forming an organic photoelectric conversion material in vacuum by a vapor deposition method or the like for preventing intermingling of an impurity and more easily producing a uniform photoelectric conversion film, when a material having high crystallinity such as phthalocyanine is vapor-deposited, the material may not be volatilized by simple heating in vacuum due to strong interaction between molecules and may not be film-formed. In this case, the phthalocyanine or naphthalocyanine is preferably made to have an axial ligand-containing structure, because the vapor deposition is facilitated. It is more preferred to have two or more axial ligands above and below with respect to the molecular plane. Furthermore, by virtue of introduction of an axial ligand, the molecules readily form a J-aggregate and absorption of light in the visible region is less allowed, so that a film structure having absorption in the infrared region can be obtained (the film formed comes to have maximum absorption at a longer wavelength with respect to the absorption as a solution). The axial ligand is preferred also in this point.

The squarylium compound (squarylium-based coloring matter) for use in the second invention is described. This coloring matter is useful as the above-described organic photoelectric conversion material, and the squarylium-based coloring matter suitable for the vapor deposition method is described in detail below.

The squarylium-based coloring matter is an organic material capable of absorbing light at a long wavelength with a simpler structure by virtue of the structure of a substituent and in the studies by the present inventors, this is found to be a material from which a low-noise photoelectric conversion element is readily obtained. Accordingly, it is considered that when the vapor deposition property is improved and the stack structure of the photoelectric conversion film is appropriately formulated, a photoelectric conversion element having high S/N sensitivity in the infrared region and having high transparency to visible light can be realized.

In the vapor deposition method, a temperature distribution is produced in the material disposed as a vapor deposition source during the vapor deposition according to the shape of vapor deposition source, the manner of elevating the temperature, and the like. Assuming that the temperature distribution is in the range from a maximum temperature T1 to a minimum temperature T2 and that the decomposition temperature is Tdecom and the temperature (vapor deposition temperature) necessary for the vapor deposition (vaporization of material) is Tdepo, since decomposition occurs in the temperature region higher than Tdecom and the material vaporizes in the temperature region higher than Tdepo, when Tdecom>T2>T1>Tdepo is satisfied, only vapor deposition can proceed without causing decomposition. At this time, if the difference between the vapor deposition temperature and the decomposition temperature is small and the temperature relationship is T2>Tdecom>T2>Tdepo or T2>T1>Tdecom>Tdepo, decomposition occurs in the temperature region higher than the decomposition temperature and there is produced a state where "decomposition of the material is occurring together with vapor deposition of the material". If the decomposition temperature decreases and becomes lower than the vapor deposition temperature, decomposition occurs earlier than vaporization of the material.

In order to enhance the vapor deposition property (that is, perform the vapor deposition without causing decomposition as much as possible), it is preferred to make at least either one, preferably both, of the following improvements:
A. make large the difference between decomposition temperature and vapor deposition temperature (ΔTd) = Tdecom -Tdepo (>0) (make the width of ΔTd larger than the temperature region of the vapor-deposition material);
B. make uniform the temperature distribution in the material to be vapor-deposited (reduce T2-T1) (cause the temperature region of the vapor-deposition material to fall within the range of ΔTd).

The measures regarding A above are "to elevate the decomposition temperature" and "to decrease the vapor deposition temperature". As for the measure of decreasing the decomposition temperature, in the squarylium compound, it is important to select a substituent which is less decomposable. In terms of strengthening the bonding between the substituent and the squarylic acid structure (in the present invention, referred to as a "2-cyclobutene-1,3-dione nucleus") at the center, a device of providing, in the substituent, a group capable of hydrogen-bonding with the oxygen atom of the squarylic acid structure (2-cyclobutene-1,3-dione nucleus) at the center may be considered. In regard to the decomposition within the substituent, formation of a condensed ring structure is considered as preferred and if a long alkyl group or the like is imparted, decomposition tends to readily occur. Easy decomposability of each substituent may be judged using as a guide the decomposition temperature measured assuming that the same substituent is present at both ends of formula (SQ-1) (A=B).

As for the method of decreasing the vapor deposition temperature, a device of weakening the intermolecular interaction is first considered. More specifically, this is a device of imparting a bulky group working out to a steric hindrance, such as tertiary-butyl group, into the structure, and thereby increasing the intermolecular distance, so that the intermolecular interaction can be weakened and vaporization can occur at a low temperature. In this case, even if the decomposition is low, the vapor deposition property can be enhanced by decreasing the vapor deposition temperature to be lower than the decomposition temperature. However, when the intermolecular distance is increased and the interaction is weakened, the charge transporting ability in the organic film is also decreased and reduction in the photoelectric conversion efficiency is incurred. Therefore, introduction of an excessive steric hindrance is not appropriate to the object of the present invention. Furthermore, introduction of a bulky group sometimes disadvantageously brings about a drop of the decomposition temperature and in turn a decrease of ΔTd. In general, as the molecular weight increases, the molecule becomes heavy and vaporization less occurs, as a result, the vapor deposition temperature rises. Also in the case of a planar molecule, a large intermolecular overlap and a small intermolecular distance is readily caused and since the intermolecular interaction is thereby increased, the vapor deposition temperature is liable to rise. From these reasons, the substituent preferably has a structure of weakening the intermolecular interaction (reducing the planarity of molecule and having a group working out to an effective steric hindrance) to an extent not impairing the photoelectric conversion and has properties such that the molecular weight is small, absorption at a long wavelength is expressed, and the decomposability is small.

As a result of intensive studies, the present inventors have found the following squarylium compound which satisfies the above-described requirements, exhibits high photoelectric conversion efficiency, and is assured of low noise and good vapor deposition property.

The squarylium compound represented by formula (SQ-1) is described below.

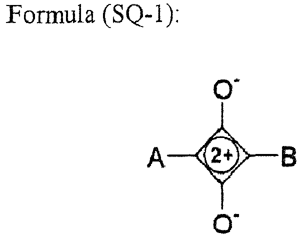

The substituent represented by A and B in formula (SQ-1) may be any substituent as long as the bonding site is an sp² carbon. The substituent includes a group containing an aryl group or a heterocyclic group. Preferred examples of the substituent include an aryl group, a heterocyclic group, and a methine group having bonded thereto an aryl or heterocyclic group, and it is preferred that the carbon atom in the hetero ring of the heterocyclic group and the methine group are bonded. The aryl group is preferably a substituted or unsubstituted aryl group having a carbon number of 6 to 30, and examples thereof include phenyl, p-tolyl, naphthyl, m-chlorophenyl, o-hexadecanoyl, aminophenyl and ferrocenyl. The heterocyclic group is preferably a monovalent group obtained by removing one hydrogen atom from a 5-or 6-membered, substituted or unsubstituted, aromatic or non-aromatic heterocyclic compound, more preferably a 5- or 6-membered aromatic heterocyclic group having a carbon number of 3 to 30, and examples thereof include 2-furyl, 2-thienyl, 2-pyrimidyl and 2-benzothiazolyl. The heterocyclic group may also be a cationic heterocyclic group such as 1-methyl-2-pyridinio and 1-methyl-2-quinolinio. As for the aryl group or heterocyclic group in the methine group having bonded thereto an aryl or heterocyclic group, those described above are preferably used. A 2-cyclobutene-1,3-dione nucleus is also included in the heterocyclic group, and examples thereof include a 2-cyclobutene-1,3-dione nucleus bonded to the methine group having bonded thereto a heterocyclic group (e.g., indolenine nucleus). The methine group includes a substituted or unsubstituted methine group. Examples of the substituent of the methine group include W described later, and preferred examples thereof include an alkyl group (preferably a substituted or unsubstituted alkyl group having a carbon number of 1 to 5, such as methyl, ethyl, propyl, butyl, benzyl and phenethyl) and an aryl group (preferably a substituted or unsubstituted aryl group having a carbon number of 6 to 30, such as phenyl, p-tolyl and naphthyl). The methine group having bonded thereto a heterocyclic group is preferably a methine group bonded to the carbon atom in the hetero ring.

In the case of using the compound represented by formula (SQ-1) for the infrared absorption, a compound where one of A and B is a methine group having bonded thereto an indolenine nucleus (preferably bonded at the 2-position of the indolenine nucleus) and another is a methine group having bonded thereto a quinoline nucleus (preferably bonded at the 2- or 4-position, more preferably at the 2-position, of the quinoline nucleus), is preferred.

In the present invention, when a specific moiety is called "a group", this means that the moiety itself may not be substituted or may be substituted by one or more species (up to a possible largest number) of substituents. For example, an "alkyl group" indicates a substituted or unsubstituted alkyl group. Also, the substituent which can be used in the compound of the present invention may be any substituent.

When such a substituent is designated as W, the substituent represented by W may be any substituent and is not particularly limited, but examples thereof include a halogen atom, an alkyl group (including a cycloalkyl group, a bicycloalkyl group and a tricycloalkyl group), an alkenyl group (including a cycloalkenyl group and a bicycloalkenyl group), an alkynyl group, an aryl group, a heterocyclic group, a cyano group, a hydroxyl group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an ammonio group, an acylamino group, an aminocarbonylamino group, an alkoxycarbonylamino group, an aryloxycarbonylamino group, a sulfamoylamino group, an alkylarylsulfonylamino group, a mercapto group, an alkylthio group, an arylthio group, a heterocyclic thio group, a sulfamoyl group, a sulfo group, an alkyl- or arylsulfinyl group, an alkyl- or arylsulfonyl group, an acyl group, an aryloxycarbonyl group, an alkoxycarbonyl group, a carbamoyl group, an aryl- or heterocyclic azo group, an imido group, a phosphino group, a phosphinyl group, a phosphinyloxy group, a phosphinylamino group, a phosphono group, a silyl group, a hydrazino group, a ureido group, a borate group (-B(OH)₂), a phosphato group (-OPO(OH)₂), a sulfato group (-OSO₃H) and other common substituents.

More specifically, W represents a halogen atom (e.g., fluorine, chlorine, bromine, iodine), an alkyl group [a linear, branched or cyclic, substituted or unsubstituted alkyl group; the alkyl group includes, for example, an alkyl group (preferably an alkyl group having a carbon number of 1 to 30, e.g., methyl, ethyl, n-propyl, isopropyl, tert-butyl, n-octyl, eicosyl, 2-chloroethyl, 2-cyanoethyl, 2-ethylhexyl), a cycloalkyl group (preferably a substituted or unsubstituted cycloalkyl group having a carbon number of 3 to 30, e.g., cyclohexyl, cyclopentyl, 4-n-dodecylcyclohexyl), a bicycloalkyl group (preferably a substituted or unsubstituted bicycloalkyl group having a carbon number of 5 to 30, namely, a monovalent group obtained by removing one hydrogen atom from a bicycloalkane having a carbon number of 5 to 30, e.g., bicyclo[1,2,2]heptan-2-yl, bicyclo[2,2,2]octan-3-yl), and a tricyclo structure having many cyclic structures; the alkyl group in the substituent described below (for example, an alkyl group in an alkylthio group) means an alkyl group having such a concept but also includes an alkenyl group and an alkynyl group], an alkenyl group [a linear, branched or cyclic, substituted or unsubstituted alkenyl group; the alkenyl group includes an alkenyl group (preferably a substituted or unsubstituted alkenyl group having a carbon number of 2 to 30, e.g., vinyl, allyl, prenyl, geranyl, oreyl), a cycloalkenyl group (preferably a substituted or unsubstituted cycloalkenyl group having a carbon number of 3 to 30, namely, a monovalent group obtained by removing one hydrogen atom form a cycloalkane having a carbon number of 3 to 30, e.g., 2-cyclopenten-1-yl, 2-cyclohexen-1-yl), a bicycloalkenyl group (a substituted or unsubstituted bicycloalkenyl group, preferably a substituted or unsubstituted bicycloalkenyl group having a carbon number of 5 to 30, namely, a monovalent group obtained by removing one hydrogen atom from a bicycloalkane having one double bond, e.g., bicyclo[2,2,1]hept-2-en-1-yl, bicyclo[2,2,2]oct-2-en-4-yl)], an alkynyl group (preferably a substituted or unsubstituted alkynyl group having a carbon number of 2 to 30, e.g., ethynyl, propargyl, trimethylsilylethynyl), an aryl group (preferably a substituted or unsubstituted aryl group having a carbon number of 6 to 30, e.g., phenyl, p-tolyl, naphthyl, m-chlorophenyl, o-hexadecanoylaminophenyl, ferrocenyl), a heterocyclic group (preferably a monovalent group obtained by removing one hydrogen atom from a 5- or 6-membered substituted or unsubstituted, aromatic or non-aromatic heterocyclic compound, more preferably a 5- or 6-membered aromatic heterocyclic group having a carbon number of 3 to 30, e.g., 2-furyl, 2-thienyl, 2-pyrimidinyl, 2-benzothiazolyl; the heterocyclic group may also be a cationic heterocyclic group such as 1-methyl-2-pyridinio and 1-methyl-2-quinolinio), a cyano group, a hydroxyl group, a nitro group, a carboxyl group, an alkoxy group (preferably a substituted or unsubstituted alkoxy group having a carbon number of 1 to 30, e.g., methoxy, ethoxy, isopropoxy, tert-butoxy, n-octyloxy, 2-methoxyethoxy), an aryloxy group (preferably a substituted or unsubstituted aryloxy group having a carbon number of 6 to 30, e.g., phenoxy, 2-methylphenoxy, 4-tert-butylphenoxy, 3-nitrophenoxy, 2-tetradecanoylaminophenoxy), a silyloxy group (preferably a silyloxy group having a carbon number of 3 to 20, e.g., trimethylsilyloxy, tert-butyldimethylsilyloxy), a heterocyclic oxy group (preferably a substituted or unsubstituted heterocyclic oxy group having a carbon number of 2 to 30, e.g., 1-phenyltetrazol-5-oxy, 2-tetrahydropyranyloxy), an acyloxy group (preferably a formyloxy group, a substituted or unsubstituted alkylcarbonyloxy group having a carbon number of 2 to 30, or a substituted or unsubstituted arylcarbonyloxy group having a carbon number of 6 to 30, e.g., formyloxy, acetyloxy, pivaloyloxy, stearoyloxy, benzoyloxy, p-rnethoxyphenylcarbonyloxy), a carbamoyloxy group (preferably a substituted or unsubstituted carbamoyloxy group having a carbon number of 1 to 30, e.g., N,N-dimethylcarbamoyloxy, N,N-diethylcarbamoyloxy, morpholinocarbonyloxy, N,N-di-n-octylaminocarbonyloxy, N-n-octylcarbamoyloxy), an alkoxycarbonyloxy group (preferably a substituted or unsubstituted alkoxycarbonyloxy group having a carbon number of 2 to 30, e.g., methoxycarbonyloxy, ethoxycarbonyloxy, tert-butoxycarbonyloxy, n-octylcarbonyloxy), an aryloxycarbonyloxy group (preferably a substituted or unsubstituted aryloxycarbonyloxy group having a carbon number of 7 to 30, e.g., phenoxycarbonyloxy, p-methoxyphenoxycarbonyloxy, p-n-hexadecyloxyphenoxycarbonyloxy), an amino group (preferably an amino group, a substituted or unsubstituted alkylamino group having a carbon number of 1 to 30, or a substituted or unsubstituted arylamino group having a carbon number of 6 to 30, e.g., amino, methylamino, dimethylamino, anilino, N-methyl-anilino, diphenylamino), an ammonio group (preferably an ammonio group or an ammonio group substituted by a substituted or unsubstituted alkyl, aryl or heterocyclic group having a carbon number of 1 to 30, e.g., trimethylammonio, triethylammonio, diphenylmethylammonio), an acylamino group (preferably a formylamino group, a substituted or unsubstituted alkylcarbonylamino group having a carbon number of 1 to 30, or a substituted or unsubstituted arylcarbonylamino group having a carbon number of 6 to 30, e.g., formylamino, acetylamino, pivaloylamino, lauroylamino, benzoylamino, 3,4,5-tri-n-octyloxyphenylcarbonylamino), an aminocarbonylamino group (preferably a substituted or unsubstituted aminocarbonylamino group having a carbon number of 1 to 30, e.g., carbamoylamino, N,N-dimethylaminocarbonylamino, N,N-diethylaminocarbonylamino, morpholinocarbonylamino), an alkoxycarbonylamino group (preferably a substituted or unsubstituted alkoxycarbonylamino group having a carbon number of 2 to 30, e.g., methoxycarbonylamino, ethoxycarbonylamino, tert-butoxycarbonylamino, n-octadecyloxycarbonylamino, N-methyl-methoxycarbonylamino), an aryloxycarbonylamino group (preferably a substituted or unsubstituted aryloxycarbonylamino group having a carbon number of 7 to 30, e.g., phenoxycarbonylamino, p-chlorophenoxycarbonylamino, m-n-octyloxyphenoxycarbonylamino), a sulfamoylamino group (preferably a substituted or unsubstituted sulfamoylamino group having a carbon number of 0 to 30, e.g., sulfamoylamino, N,N-dimethylaminosulfonylamino, N-n-octylaminosulfonylamino), an alkyl- or arylsulfonylamino group (preferably a substituted or unsubstituted alkylsulfonylamino group having a carbon number of 1 to 30, or a substituted or unsubstituted arylsulfonylamino group having a carbon number of 6 to 30, e.g., methylsulfonylamino, butylsulfonylamino, phenylsulfonylamino, 2,3,5-trichlorophenylsulfonylamino, p-methylphenylsulfonylamino), a mercapto group, an alkylthio group (preferably a substituted or unsubstituted alkylthio group having a carbon number of 1 to 30, e.g., methylthio, ethylthio, n-hexadecylthio), an arylthio group (preferably a substituted or unsubstituted arylthio group having a carbon number of 6 to 30, e.g., phenylthio, p-chlorophenylthio, m-methoxyphenylthio), a heterocyclic thio group (preferably a substituted or unsubstituted heterocyclic thio group having a carbon number of 2 to 30, e.g., 2-benzothiazolylthio, 1-phenyltetrazol-5-ylthio), a sulfamoyl group (preferably a substituted or unsubstituted sulfamoyl group having a carbon number of 0 to 30, e.g., N-ethylsulfamoyl, N-(3-dodecyloxypropyl)sulfamoyl, N,N-dimethylsulfamoyl, N-acetylsulfamoyl, N-benzoylsulfamoyl, N-(N'-phenylcarbamoyl)sulfamoyl), a sulfo group, an alkyl- or arylsulfinyl group (preferably a substituted or unsubstituted alkylsulfinyl group having a carbon number of 1 to 30, or a substituted or unsubstituted arylsulfinyl group having a carbon number of 6 to 30, e.g., methylsulfinyl, ethylsulfinyl, phenylsulfinyl, p-methylphenylsulfinyl), an alkyl- or arylsulfonyl group (preferably a substituted or unsubstituted alkylsulfonyl group having a carbon number of 1 to 30, or a substituted or unsubstituted arylsulfonyl group having a carbon number of 6 to 30, e.g., methylsulfonyl, ethylsulfonyl, phenylsulfonyl, p-rnethylphenylsulfonyl), an acyl group (preferably a formyl group, a substituted or unsubstituted alkylcarbonyl group having a carbon number of 2 to 30, a substituted or unsubstituted arylcarbonyl group having a carbon number of 7 to 30, or a substituted or unsubstituted heterocyclic carbonyl group having a carbon number of 4 to 30 and being bonded to a carbonyl group through the carbon atom, e.g., acetyl, pivaloyl, 2-chloroacetyl, stearoyl, benzoyl, p-n-octyloxyphenylcarbonyl, 2-pyridylcarbonyl, 2-furylcarbonyl), an aryloxycarbonyl group (preferably a substituted or unsubstituted aryloxycarbonyl group having a carbon number of 7 to 30, e.g., phenoxycarbonyl, o-chlorophenoxycarbonyl, m-nitrophenoxycarbonyl, p-tert-butylphenoxycarbonyl), an alkoxycarbonyl group (preferably a substituted or unsubstituted alkoxycarbonyl group having a carbon number of 2 to 30, e.g., methoxycarbonyl, ethoxycarbonyl, tert-butoxycarbonyl, n-octadecyloxycarbonyl), a carbamoyl group (preferably a substituted or unsubstituted carbamoyl group having a carbon number of 1 to 30, e.g., carbamoyl, N-methylcarbamoyl, N,N-dimethylcarbamoyl, N,N-di-n-octylcarbamoyl, N-(methylsulfonyl)carbamoyl), an aryl or heterocyclic azo group (preferably a substituted or unsubstituted arylazo group having a carbon number of 6 to 30, or a substituted or unsubstituted heterocyclic azo group having a carbon number of 3 to 30, e.g., phenylazo, p-chlorophenylazo, 5-ethylthio-1,3,4-thiadiazol-2-ylazo), an imido group (preferably N-succinimido or N-phthalimido), a phosphino group (preferably a substituted or unsubstituted phosphino group having a carbon number of 2 to 30, e.g., dimethylphosphino, diphenylphosphino, methylphenoxyphosphino), a phosphinyl group (preferably a substituted or unsubstituted phosphinyl group having a carbon number of 2 to 30, e.g., phosphinyl, dioctyloxyphosphinyl, diethoxyphosphinyl), a phosphinyloxy group (preferably a substituted or unsubstituted phosphinyloxy group having a carbon number of 2 to 30, e.g., diphenoxyphosphinyloxy, dioctyloxyphosphinyloxy), a phosphinylamino group (preferably a substituted or unsubstituted phosphinylamino group having a carbon number of 2 to 30, e.g., dimethoxyphosphinylamino, dimethylaminophosphinylamino), a phospho group, a silyl group (preferably a substituted or unsubstituted silyl group having a carbon number of 3 to 30, e.g., trimethylsilyl, triethylsilyl, triisopropylsilyl, tert-butyldimethylsilyl, phenyldimethylsilyl), a hydrazino group (preferably a substituted or unsubstituted hydrazino group having a carbon number of 0 to 30, e.g., trimethylhydrazino), or a ureido group (preferably a substituted or unsubstituted ureido group having a carbon number of 0 to 30, e.g., N,N-dimethylureido).

Also, two Ws may form a ring in cooperation (an aromatic or non-aromatic hydrocarbon or heterocyclic ring or a polycyclic condensed ring comprising a combination of these rings may be formed, and examples thereof include a benzene ring, a naphthalene ring, an anthracene ring, a phenanthrene ring, a fluorene ring, a triphenylene ring, a naphthacene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolidine ring, a quinoline ring, a phthalazine ring, a naphthylidine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiine ring, a phenothiazine ring and a phenazine ring).

Among these substituents W, those having a hydrogen atom may be deprived of the hydrogen atom and further substituted by the above-described group. Examples of such a substituent include a -CONHSO₂- group (such as sulfonylcarbamoyl group and carbonylsulfamoyl group), a -CONHCO- group (such as carbonylcarbamoyl group) and an - SO₂NHSO₂- group (such as sulfonylsulfamoyl group). Specific examples thereof include an alkylcarbonylaminosulfonyl group (e.g., acetylaminosulfonyl), an arylcarbonylaminosulfonyl group (e.g., benzoylaminosulfonyl), an alkylsulfonylaminocarbonyl group (e.g., methylsulfonylaminocarbonyl) and an arylsulfonylaminocarbonyl group (e.g., p-methylphenylsulfonylaminocarbonyl).

In the present invention, the compound represented by formula (SQ-1) is preferably a compound selected from the compounds of formula (SQ-2):

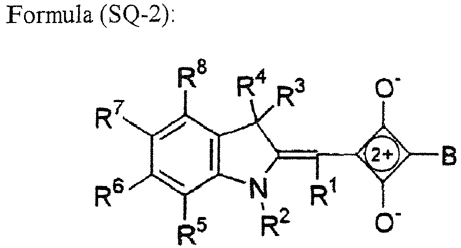

The substituent represented by R¹ to R⁸ in formula (SQ-2) may be any substituent, but examples thereof include the above-described W. R¹ is preferably a hydrogen atom, a methyl group or a phenyl group, more preferably a hydrogen atom or a methyl group. R² is preferably an alkyl group (e.g., methyl, ethyl) or a phenyl group, more preferably a methyl group. R³ and R⁴ each independently preferably an alkyl group (e.g., methyl, ethyl, propyl, butyl) or a phenyl group, and it is more preferred that both are a methyl group. R⁵ to R⁸ are preferably such that all are a hydrogen atom or any of the pairs R⁵ and R⁶, R⁶ and R⁷, and R⁷ and R⁸ are benzocondensed, with the remaining being a hydrogen atom, more preferably such that all are a hydrogen atom. B has the same meaning as in formula SQ-1 and in use for infrared absorption, is preferably an unsubstituted methine group having bonded thereto a quinoline nucleus, a pyrylium nucleus, a thiopyrylium nucleus, an azulene nucleus or a dihydroperimidine nucleus, more preferably an unsubstituted methine group having bonded thereto a quinoline nucleus, and the preferred bonding position is the same as that in formula (SQ-1).

In the present invention, the compound represented by formula (SQ-2) is preferably a compound selected from the compounds of formula (SQ-3):

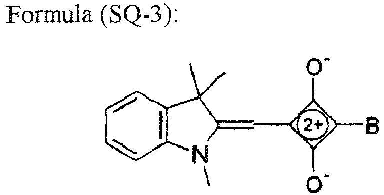

In formula (SQ-3), B has the same meaning as in formula (SQ-1) and the preferred range is also the same.

In particular, the indolenine nucleus structure bonded to the methine group in formula (SQ-3) is important, and this structure is considered to have an effect of enhancing the photoelectric conversion efficiency, decreasing the vapor deposition temperature and raising the decomposition temperature. In view of the vapor deposition property, a simple indolenine structure of formula (SQ-3) is preferred, where the molecular weight is not reduced for decreasing the vapor deposition temperature or a group which increases the decomposability is not introduced.

In order to obtain absorption at a long wavelength for the infrared absorption, the structure of the substituent B is important. However, even when long wavelength absorption is obtained, if the decomposability is high, the vapor deposition property decreases and this is improper. As regards easy decomposability of each substituent, the decomposition temperature when the same substituent is present at both ends of formula (SQ-1) (A=B) is preferably 200°C or more.

Examples of the compounds represented by formulae (SQ-1), (SQ-2) and (SQ-3) for use in the present invention are set forth below, but the present invention is not limited to these examples.

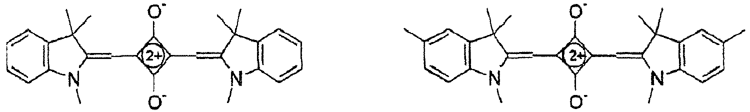

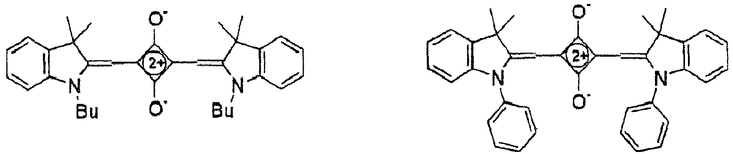

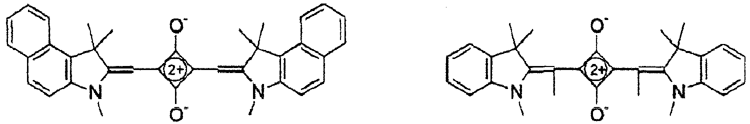

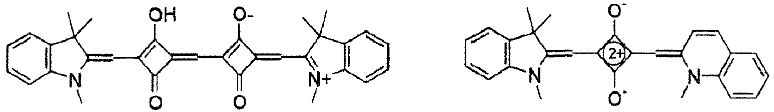

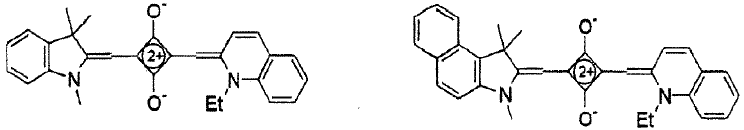

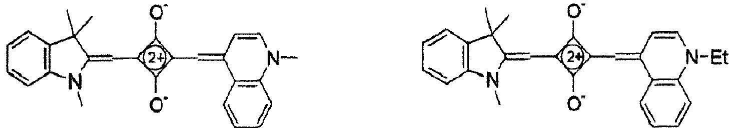

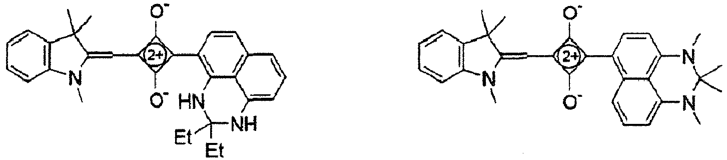

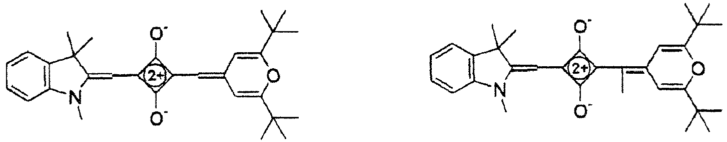

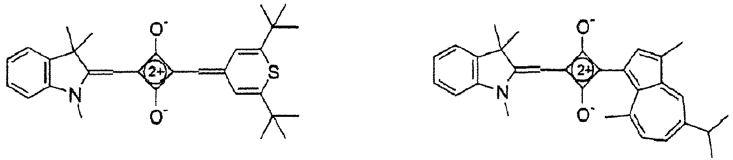

The compounds represented by formulae (SQ-1), (SQ-2) and (SQ-3) and specific examples of the compounds are indicated by one chemical formula, but indication of the chemical formula in this field can take a resonance structure or the like and those indicated by other indications are of course included in the present invention.

The compounds in those specific examples can be synthesized by referring to the related-art literature (for example, Dyes and Pigments, 21, 227-234 (1993)).

In the second invention, the compound represented by formula (SQ-1), (SQ-2) or (SQ-3) is contained, as the organic photoelectric conversion material, in the photoelectric conversion film.

In order to apply the thus-constructed photoelectric conversion element comprising a photoelectric conversion part A to a visible•infrared imaging device, for allowing the photoelectric conversion part A to obtain information other than the human visibility, the absorption peak in the infrared region of the organic photoelectric conversion material contained in the photoelectric conversion film 12 is preferably present at a wavelength of 700 nm or more, and the absorptance at that wavelength is preferably 50% or more, more preferably 80% or more. Furthermore, in order to sufficiently obtain a visible light signal at the lower side of the photoelectric conversion part A, the photoelectric conversion part A as a whole preferably transmits 50% or more of visible light, more preferably 75% or more of visible light. The visible light transmittance of the photoelectric conversion part A can be adjusted by appropriately selecting the construction material and thickness of each of the upper electrode 13, the lower electrode 11 and the photoelectric conversion film 12.

The light transparency of the lower electrode 11 and upper electrode 13 greatly affects the infrared light absorptance and visible light absorptance of the underlayer thereof. When the incident light is absorbed and reflected in the lower electrode 11 and the upper electrode 13, the absolute amount of light reaching the underlayer decreases and this leads directly to reduction in the sensitivity. In order to transmit a larger amount of light to the underlayer and increase the sensitivity in the photoelectric conversion film 12, the visible light and infrared light transmittance of the upper electrode 13 is preferably 90% or more, more preferably 95% or more. Also, in order to transmit a larger amount of light to the underlayer and increase the sensitivity in a visible light detecting element provided on the lower side of the photoelectric conversion element, the visible light transmittance of the lower electrode 11 is preferably 90% or more, more preferably 95% or more.

As for the material of the lower electrode 11 and upper electrode 13 satisfying these conditions, a transparent electrically conductive oxide (TCO; transparent conducting oxide) exhibiting high transmittance for visible light and infrared light and having a small resistance value can be preferably used. A metal thin film of Au or the like may be used, but when a transmittance of 90% or more is intended to obtain, the resistance value extremely increases. Therefore, TCO is preferred. Examples of TCO which can be preferably used include ITO, IZO, AZO, FTO, SnO₂, TiO₂ and ZnO₂.

In the case of film-forming a transparent electrically conductive material such as TCO on the photoelectric conversion film 12 to form the upper electrode 13, a DC short or an increase of leak current is sometimes brought about. One of causes thereof is considered because fine cracks introduced into the photoelectric conversion film 12 are coveraged by a dense film of TCO or the like and conduction with the transparent electrically conductive material film on the opposite side increases. Therefore, in the case of an electrode having relatively poor film quality such as A1, the increase of leak current is less caused. The increase of leak current can be greatly suppressed by controlling the thickness of the transparent electrically conducting material film with respect to the thickness (that is, the crack depth) of the photoelectric conversion film 12. The thickness of the transparent electrically conductive material film, that is, the thickness of the upper electrode 13, is preferably 1/5 or less, preferably 1/10 or less, of the thickness of the photoelectric conversion film 12.

Usually, when the thickness of the transparent electrically conductive material film is made smaller than a certain range, an abrupt increase of the resistance value is brought about, but in the photoelectric conversion element of the present invention, the sheet resistance may be preferably from 100 to 10,000 Ω/sq. and the latitude as to in which range the film thickness can be reduced is large. Also, as the thickness of the transparent electrically conductive material film is smaller, the amount of light absorbed becomes small and the light transmittance is generally increased. The increase of transmittance favors an increase of light absorption in the photoelectric conversion film 12 and an increase of photoelectric conversion performance, and this is very preferred. Considering the suppression of leak current, the increase of resistance value of thin film and the increase of transmittance, which are associated with the reduction in the thickness of the transparent electrically conductive material film, the thickness of the transparent electrically conductive material film is preferably from 5 to 100 nm, more preferably from 5 to 20 nm.

In the case where irregularities are present on the lower electrode 11 surface or dusts are adhering to the lower electrode 11 surface, when a low molecular organic photoelectric conversion material is vapor-deposited thereon to form the photoelectric conversion film 12, the irregularity portion is liable to allow only shallow formation of fine cracks in the photoelectric conversion film 12 or thin formation of the photoelectric conversion film 12. At this time, when the upper electrode 13 is further formed thereon, the cracks are coveraged by the transparent electrically conductive material film, and the photoelectric conversion film 12 and the upper electrode 13 are partially put into proximity, as a result, a DC short or an increase of leak current is readily caused. This tendency is significant particularly when TCO is used as the upper electrode 13. As one method for preventing such an increase of leak current, a subbing film alleviating the irregularities is preferably formed on the lower electrode 11. As for the subbing film, when a method of forming the film by spin-coating a polymer-based material such as polyaniline, polythiophene, polypyrrole, polycarbazole, PTPDES and PTPDEK is used, the effect is large. In the case of forming the photoelectric conversion film 12 in vacuum by a vapor deposition method or the like for preventing intermingling of an impurity and more easily producing a uniform stack film, an amorphous film is preferably used as the subbing layer.

In regard to the combination of the lower electrode 11, the organic photoelectric conversion material and the upper electrode 13, which enables the photoelectric conversion part A to have a visible light transmittance of 50% or more, as described later in Examples, there may be considered a combination where the lower electrode 11 and the upper electrode 13 each is ITO and the organic photoelectric conversion material is tin phthalocyanine. Other than this combination, when the lower electrode 11 and the upper electrode 13 each is IZO, AZO, FTO, SnO₂ TiO₂ or ZnO₂ and the organic photoelectric conversion material is any one of the above-described dyes, a visible light transmittance of 50% or more of the photoelectric conversion part A can be realized.

### (Second Embodiment)

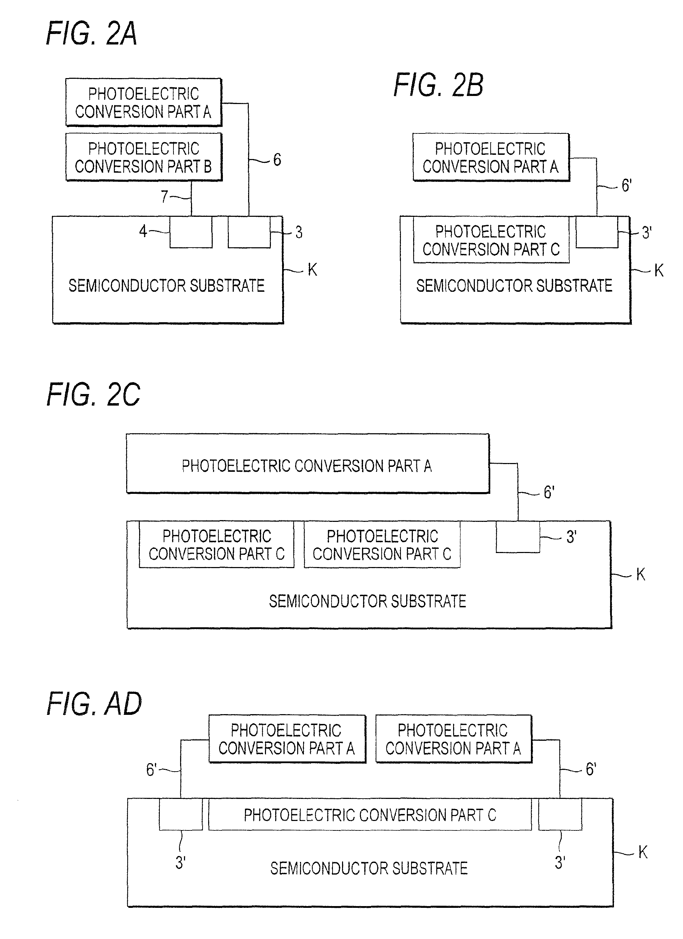

Figs. 2A to 2D are cross-sectional schematic views roughly showing the construction of the photoelectric conversion element in the second embodiment of the present invention.

The photoelectric conversion element shown in Fig. 2A comprises a semiconductor substrate K such as silicon, a visible light photoelectric conversion part B stacked on the upper side of the semiconductor substrate K, and the photoelectric conversion part A shown in Fig. 1 stacked on the upper side of the visible light photoelectric conversion part B.

The visible light photoelectric conversion part B has almost the same construction as the photoelectric conversion part A and as for the organic photoelectric conversion material constituting the photoelectric conversion film 12 of the photoelectric conversion part A, a material having an absorption peak in the visible region of an absorption spectrum in the combined range of a visible region and an infrared region (the range at a wavelength of 400 nm or more) and generating an electric charge according to the light absorbed is used.

In the semiconductor substrate K, an accumulation part 3 for accumulating an electric charge generated in the photoelectric conversion film 12 of the photoelectric conversion part A and moved to the upper electrode 13 is formed and this accumulation part 3 and the upper electrode 13 are electrically connected by a connection part 6. Also, in the semiconductor substrate K, an accumulation part 4 for accumulating an electric charge generated in the photoelectric conversion film of the photoelectric conversion part B and moved to the upper electrode is formed and this accumulation part 4 and the upper electrode are electrically connected by a connection part 7.

The photoelectric conversion element shown in Fig. 2B comprises a semiconductor substrate K such as silicon and the photoelectric conversion part A shown in Fig. 1 stacked on the upper side of the semiconductor substrate K. In the semiconductor substrate K on the lower side of the photoelectric conversion part A, a visible light photoelectric conversion part C having an absorption peak in the visible region of an absorption spectrum in the combined range of a visible region and an infrared region (the range at a wavelength of 400 nm or more) and generating an electric charge according to the light absorbed is formed. Also, in the semiconductor substrate K, an accumulation part 3' for accumulating an electric charge generated in the photoelectric conversion film 12 of the photoelectric conversion part A and moved to the upper electrode 13 is formed and this accumulation part 3' and the upper electrode 13 are electrically connected by a connection part 6'. The visible light photoelectric conversion part C is composed of, for example, the related-art pn-junction photodiode.

By virtue of the constructions shown in Figs. 2A and 2B, a photoelectric conversion element capable of acquiring a signal according to infrared light by an electric charge generated in the photoelectric conversion part A provided as the upper layer and acquiring a signal according to visible light by an electric charge generated in the photoelectric conversion part B or photoelectric conversion part C provided on the lower side of the photoelectric conversion part A can be realized.

In the case of the construction of Fig. 2A, for example, by forming the photoelectric conversion film of the photoelectric conversion part B from a quinacridone-based organic material (e.g., quinacridone), a signal according to infrared light and a signal according to G light can be acquired at the same time. Accordingly, when many photoelectric conversion elements of Fig. 2A are two-dimensionally arrayed on the same plane and a signal read-out circuit such as CCD or CMOS circuit for reading out a signal according to an electric charge generated in each photoelectric conversion element is provided in the semiconductor substrate K, an infrared•visible imaging device capable of simultaneously photographing an infrared image according to infrared light and a black-and-white image according to G light can be realized.

Also, when many photoelectric conversion elements fabricated by forming the photoelectric conversion film of the photoelectric conversion part B from a quinacridone-based organic material (e.g., quinacridone), many photoelectric conversion elements fabricated by forming the photoelectric conversion film of the photoelectric conversion part B from a phthalocyanine-based organic material (e.g., zinc phthalocyanine), and many photoelectric conversion elements fabricated by forming the photoelectric conversion film of the photoelectric conversion part B from a porphyrin-based organic material are two-dimensionally arrayed in the same plane and a signal read-out circuit such as CCD or CMOS circuit for reading out a signal according to an electric charge generated in each photoelectric conversion element is provided in the semiconductor substrate K, an infrared•visible imaging device capable of simultaneously photographing an infrared image according to infrared light and a color image according to R, G and B lights through the related-art signal processing can be realized.

Furthermore, in Fig. 2A, by further providing two photoelectric conversion parts B between the photoelectric conversion part A and the photoelectric conversion part B or between the semiconductor substrate K and the photoelectric conversion part B and employing quinacridone, zinc phthalocyanine and a porphyrin-based organic compound as respective materials of the photoelectric conversion films of three photoelectric conversion parts B in total, a signal according to infrared light can be acquired from the photoelectric conversion part A and signals according to R, G and B lights can be acquired from those three photoelectric conversion elements B. Therefore, when many photoelectric conversion elements of Fig. 2A are two-dimensionally arrayed on the same plane and a signal read-out circuit such as CCD or CMOS circuit for reading out a signal according to an electric charge generated in each photoelectric conversion element is provided in the semiconductor substrate K, an infrared•visible imaging device capable of simultaneously photographing an infrared image according to infrared light and a color image according to R, G and B lights can be realized. Of course, a construction where one photoelectric conversion part B or three or more photoelectric conversion parts B are provided between the photoelectric conversion part A and the photoelectric conversion part B or between the semiconductor substrate K and the photoelectric conversion part B can also be employed according to usage.

In the case of the construction of Fig. 2B, the photoelectric conversion part C itself is a pn-junction photodiode fundamentally having sensitivity to light at a wavelength of 1,100 nm or less and therefore, has sensitivity to light other than the infrared light absorbed by the photoelectric conversion part A. When there is no substance absorbing light other than the photoelectric conversion part A, the light entering the photoelectric conversion part C becomes the entire light at wavelengths transmitted through the photoelectric conversion part A, and a signal according to infrared light and a signal according to visible light can be simultaneously acquired. Therefore, when many photoelectric conversion elements of Fig. 2B are two-dimensionally arrayed on the same plane and a signal read-out circuit such as CCD or CMOS circuit for reading out a signal according to an electric charge generated in each photoelectric conversion element is provided in the semiconductor substrate K, an infrared•visible imaging device capable of simultaneously photographing an infrared image according to infrared light and a black-and-white image according to visible light can be realized.

In regard to the photoelectric conversion part C, as described in U.S. Patent 5,965,875, when an imaging device is fabricated by forming a pn-junction face at a R light absorption depth, a G light absorption depth and a B light absorption depth and stacking three photoelectric conversion parts C in the depth direction such that the wavelength to be absorbed is separated in the silicon depth direction to acquire a signal corresponding to each absorption wavelength, a color signal can be acquired from the visible light transmitted through the photoelectric conversion part A, and a signal according to infrared light and signals according to R, G and B lights can be acquired at the same time. Of course, a construction where two photoelectric conversion parts C or four or more photoelectric conversion parts C are provided in the semiconductor substrate K on the lower side of the photoelectric conversion part A can also be employed according to usage.

Furthermore, when a spectral filter transmitting light in a specific wavelength region is disposed on the upper side of the photoelectric conversion part A, the light allowed to enter the photoelectric conversion C can be separated. As for the spectral filter, a primary color or complementary color filter used in a normal CCD or CMOS color image sensor can be employed. The color filter used in a CCD or CMOS color image sensor generally has a property of transmitting also a part of infrared light and therefore, even when the color filter is disposed on the upper side of the photoelectric conversion part A, infrared light can be made to enter the photoelectric conversion part A.

For example, when many photoelectric conversion elements where an R color filter transmitting R light and a part of infrared light is provided on the upper side of the photoelectric conversion part A of Fig. 2B, many photoelectric conversion elements where a G color filter transmitting G light and a part of infrared light is provided on the upper side of the photoelectric conversion part A of Fig. 2B, and many photoelectric conversion elements where a B color filter transmitting B light and a part of infrared light is provided on the upper side of the photoelectric conversion part A of Fig. 2B, are arrayed on the same plane and a signal read-out circuit such as CCD or CMOS circuit for reading out a signal according to an electric charge generated in each photoelectric conversion element is provided in the semiconductor substrate K, an infrared•visible imaging device capable of simultaneously photographing an infrared image and a color image through the related-art signal processing can be realized.

According to the photoelectric conversion elements shown in Figs. 2(a) and (b), photographic conversion parts detecting different lights are stacked in the longitudinal direction, so that as compared with a normal color filter mode, almost all incident light can be taken out as a signal and by virtue of no loss in the light quantity, high sensitivity can be realized. Furthermore, in a normal Si photoelectric conversion device, an infrared cut filter is provided for cutting a signal based on infrared light, but the role thereof can be partially or entirely fulfilled by the photoelectric conversion part A as the uppermost layer and therefore, when applied to an imaging device, an effect of partially eliminating the use of an infrared cut filter can be obtained.

Incidentally, in Figs. 2A and 2B, one or more photoelectric conversion elements B or photoelectric conversion parts C are stacked on the lower side of the photoelectric conversion part A, but a construction where, as shown in Fig. 2C, in the semiconductor substrate K on the lower side of the photoelectric conversion part A, a plurality of photoelectric conversion parts C are formed in array in the vertical direction (the direction parallel to the semiconductor substrate K surface) with respect to the incident direction of light entering the semiconductor substrate K, may also be considered. For example, three pn-junction photodiodes are formed as the photoelectric conversion part C in the semiconductor substrate K on the lower side of the photoelectric conversion part A to array in the above-described vertical direction, and an R color filter, a G color filter and a B color filter are disposed respectively on these three pn-junction photodiodes. Then, a large number of the obtained photoelectric conversion elements are disposed on the same plane, and a signal read-out circuit such as CCD or CMOS circuit for reading out a signal according to an electric charge generated in each photoelectric conversion element is provided in the semiconductor substrate K, whereby an infrared•visible imaging device capable of simultaneously photographing an infrared image according to infrared light and a color image, with a one-to-one correspondence between each photoelectric conversion element and a pixel, can be realized.

The pixel size of the photoelectric conversion A and the pixel size of the photoelectric conversion part B•C can be allotted to different sizes from each other.

In Fig. 2C, a plurality of photoelectric conversion parts C are disposed to correspond to one photoelectric conversion part A, but it is also possible to employ an embodiment of allotting the plurality of conversion parts to the incident side and the one conversion part to the substrate side, or depending on usage, as shown in Fig. 2D, to fabricate a construction where one photoelectric conversion part C corresponds to two photoelectric conversion parts A.

Incidentally, in the construction example shown in Figs. 2A to 2D, as regards the photoelectric conversion part A and the photoelectric conversion part B, the photoelectric conversion part A and the photoelectric conversion part B are of course overlapped as viewed in plane such that light transmitted through the photoelectric conversion part A enters the photoelectric conversion part B. Similarly, as regards the photoelectric conversion part A and the photoelectric conversion part C, the photoelectric conversion part A and the photoelectric conversion part C are of course overlapped as viewed in plane such that light transmitted through the photoelectric conversion part A enters the photoelectric conversion part C.

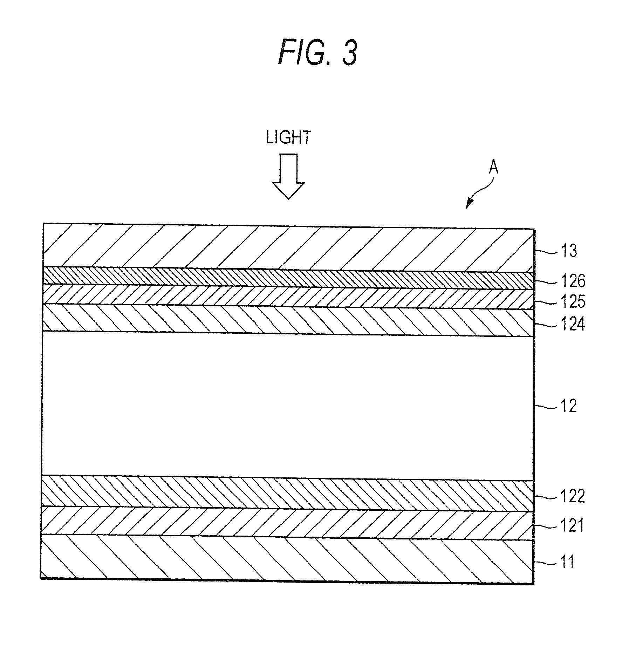

A more preferred embodiment of the photoelectric conversion part A shown in Fig. 1 is described below. In the photoelectric conversion part A described here has a construction shown in Fig. 3. In Fig. 3, the same constituents as those in Fig. 1 are denoted by the same reference numerals.

In the photoelectric conversion part A, the voltage applying method or the material construction of element is preferably performed such that a signal electric charge having lower performance of transporting a hole and an electron in the organic film is collected from the upper electrode 13 side on the light incident side, because the photoelectric conversion efficiency is high and the spectral sensitivity becomes sharp. In the photoelectric conversion film 12 of the photoelectric conversion part A, the light absorption occurs mainly on the light incident side and therefore, when an electric charge having lower transport performance is collected from the upper electrode 13 closer to the light incident side, the charge transport distance becomes short and deactivation of the electric charge during transport is reduced, favoring an increase of efficiency. If the above-described direction from which the electric charge is collected is reversed, the electric charge generation part becomes closer to the upper electrode 13 side and the wavelength of larger absorptance requires a longer transport distance to make it difficult to collect an electric charge. Also, the site generating an electric charge comes to locate in the back of film and since the wavelength of low absorptance allowing light to reach the back of film travels a short transport distance, the collection efficiency increases. As a result, the spectral sensitivity becomes broad with respect to the original absorption spectrum. In the organic film, many materials have high performance of transporting a hole and in this case, a mode of applying a voltage to collect an electron from the upper electrode 13, collecting a hole from the lower electrode 11, and accumulating, transferring and reading out a signal is preferred.

In the following, a case of collecting an electron from the upper electrode 13 is described. In the case of collecting a hole from the upper electrode 13, this may be attained by reversing the order of film formation except for a subbing film 121 and a work function adjusting film 126, and as for the subbing film 121, the material may be selected or depending on the case, changed by taking into consideration the transport performance. The work function adjusting film 126 may be changed to select a material having a large work function.

It is preferred to provide, as shown in Fig. 3, a subbing film 121 and an electron blocking film 122 between the photoelectric conversion film 12 and the lower electrode 11 of the photoelectric conversion part A and provide a hole blocking film 124, a hole blocking and buffer film 125 and a work function adjusting film 126 between the photoelectric conversion film 12 and the upper electrode 13.

The organic photoelectric conversion material constituting the photoelectric conversion film 12 preferably contains at least either an organic p-type semiconductor or an organic n-type semiconductor.

The organic p-type semiconductor (compound) is a donative organic semiconductor (compound) mainly typified by a hole-transporting organic compound and indicates an organic compound having a property of readily donating an electron, more specifically, an organic compound having a smaller ionization potential when two organic materials are used in mutual contact. Accordingly, as for the donative organic compound, any organic compound can be used as long as it is an organic compound having an electron donating property. Examples of the compound which can be used include a triarylamine compound, a benzidine compound, a pyrazoline compound, a styrylamine compound, a hydrazone compound, a triphenylmethane compound, a carbazole compound, a polysilane compound a thiophene compound, a phthalocyanine compound, a cyanine compound, a merocyanine compound, an oxonol compound, a polyamine compound, an indole compound, a pyrrole compound, a pyrazole compound, a polyarylene compound, a condensed aromatic carbocyclic compound (e.g., naphthalene derivative, anthracene derivative, phenanthrene derivative, tetracene derivative, pyrene derivative, perylene derivative, fluoranthene derivative), and a metallic complex having a nitrogen-containing heterocyclic compound as a ligand. The donative organic semiconductor is not limited to these compounds, and an organic compound may be used if it has a smaller ionization potential than the organic compound used as an n-type (acceptive) compound.

The organic n-type semiconductor (compound) is an acceptive organic semiconductor (compound) mainly typified by an electron-transporting organic compound and indicates an organic compound having a property of readily accepting an electron, more specifically, an organic compound having a larger electron affinity when two organic compounds are used in mutual contact. Accordingly, as for the acceptive organic compound, any organic compound can be used as long as it is an organic compound having an electron accepting property. Examples thereof include a condensed aromatic carbocyclic compound (e.g., naphthalene derivative, anthracene derivative, phenanthrene derivative, tetracene derivative, pyrene derivative, perylene derivative, fluoranthene derivative), a 5- to 7-membered heterocyclic compound containing a nitrogen atom, an oxygen atom or a sulfur atom (e.g., pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyralidine, pyrrolopyridine, thiadiazolopyridine, dibenzazepine, tribenzazepine), a polyarylene compound, a fluorene compound, a cyclopentadiene compound, a silyl compound, and a metal complex having a nitrogen-containing heterocyclic compound as a ligand. The acceptive organic semiconductor is not limited to these compounds, and an organic compound may be used if it has a larger electron affinity than the organic compound used as the donative organic compound.

The metal complex compound is described below. The metal complex compound is a metal complex having at least one ligand containing a nitrogen, oxygen or sulfur atom coordinated to a metal. The metal ion in the metal complex is not particularly limited but is preferably beryllium ion, magnesium ion, aluminum ion, gallium ion, zinc ion, indium ion or tin ion, more preferably beryllium ion, aluminum ion, gallium ion or zinc ion, still more preferably aluminum ion or zinc ion. The ligand contained in the metal complex includes various know ligands, but examples thereof include ligands disclosed in H. Yersin, Photochemistry and Photophysics of Coordination Compounds, Springer-Verlag (1987), and Akio Yamamoto, Yuki Kinzoku Kagaku -Kiso to Oyo- (Organic Metal Chemistry - Foundation and Application-), Shokabo (1982).

The ligand is preferably a nitrogen-containing heterocyclic ligand (preferably having a carbon number of 1 to 30, more preferably from 2 to 20, still more preferably from 3 to 15; which may be a monodentate ligand or a bidentate or greater ligand and is preferably a bidentate ligand, such as pyridine ligand, bipyridyl ligand, quinolinol ligand, hydroxyphenylazole ligand (e.g., hydroxyphenylbenzimidazole, hydroxyphenylbenzoxazole, hydroxyphenylimidazole)), an alkoxy ligand (preferably having a carbon number of 1 to 30, more preferably from 1 to 20, still more preferably from 1 to 10, such as methoxy, ethoxy, butoxy and 2-ethylhexyloxy), an aryloxy ligand (preferably having a carbon number of 6 to 30, more preferably from 6 to 20, still more preferably from 6 to 12, such as phenyloxy, 1-naphthyloxy, 2-naphthyloxy, 2,4,6-trimethylphenyloxy and 4-biphenyloxy), a heteroaryloxy ligand (preferably having a carbon number of 1 to 30, more preferably from 1 to 20, still more preferably from 1 to 12, such as pyridyloxy, pyrazyloxy, pyrimidyloxy and quinolyloxy), an alkylthio ligand (preferably having a carbon number of 1 to 30, more preferably from 1 to 20, still more preferably from 1 to 12, such as methylthio and ethylthio), an arylthio ligand (preferably having a carbon number of 6 to 30, more preferably from 6 to 20, still more preferably from 6 to 12, such as phenylthio), a heterocyclic ring-substituted thio ligand (preferably having a carbon number of 1 to 30, more preferably from 1 to 20, still more preferably from 1 to 12, such as pyridylthio, 2-benzimizolylthio, 2-benzoxazolylthio and 2-benzothiazolylthio), or a siloxy ligand (preferably having a carbon number of 1 to 30, more preferably from 3 to 25, still more preferably from 6 to 20, such as triphenylsiloxy, triethoxysiloxy group and triisopropylsiloxy group), more preferably a nitrogen-containing heterocyclic ligand, an aryloxy ligand, a heteroaryloxy group or a siloxy ligand, still more preferably a nitrogen-containing heterocyclic ligand, an aryloxy ligand or a siloxy ligand.

The photoelectric conversion film 12 preferably has a p-type semiconductor layer and an n-type semiconductor layer, where at least one of the p-type semiconductor and the n-type semiconductor is an organic semiconductor and at the same time, a bulk heterojunction structure layer containing the p-type semiconductor and the n-type semiconductor is provided as an intermediate layer between those semiconductor layers. In such a case, by virtue of containing a bulk heterojunction structure in the photoelectric conversion film 12, the defect of the photoelectric conversion film 12 that the carrier diffusion length is short can be compensated and the photoelectric conversion efficiency can be enhanced. Incidentally, the bulk heterojunction structure is described in detail in Japanese Patent Application No. 2004-080639.

The photoelectric conversion film 12 preferably has a structure containing two or more repeating structures (tandem structures) of a pn-junction layer formed by a p-type semiconductor layer and an n-type semiconductor layer, and it is more preferred to insert an electrically conductive material thin layer between the repeating structures. The number of the repeating structures (tandem structures) of the pn-junction layer is not particularly limited but for improving the photoelectric conversion efficiency, and the number is preferably from 2 to 50, more preferably from 2 to 30, still more preferably from 2 or 10. The electrically conductive material is preferably silver or gold, and most preferably silver. The tandem structure is described in detail in Japanese Patent Application No. 2004-079930.

The photoelectric conversion film 12 preferably contains a p-type semiconductor layer and an n-type semiconductor layer (preferably a mixed and dispersed layer (bulk heterojunction layer)), where at least one of the p-type semiconductor and the n-type semiconductor contains an organic compound controlled in the alignment, more preferably where both the p-type semiconductor and the n-type semiconductor contain an organic compound controlled (or capable of being controlled) in the alignment. As for the organic compound, a compound having a π-conjugate electron is preferably used, and the π-electro plane is preferably aligned not perpendicularly to the substrate (electrode substrate) but at an angle close to parallel. The angle with respect to the substrate is preferably from 0 to 80°, more preferably from 0 to 60°, still more preferably from 0 to 40°, yet still more preferably from 0 to 20°, even yet still more preferably from 0 to 10°, and most preferably 0° (that is, in parallel to the substrate). The layer of the organic compound controlled in the alignment as above may be contained as a part of the entire photoelectric conversion film 12, but the ratio of the portion controlled in the alignment to the entire photoelectric conversion film 12 is preferably 10% or more, more preferably 30% or more, still more preferably 50% or more, yet still more preferably 70% or more, even yet still more preferably 90% or more, and most preferably 100%. By virtue of thus controlling the alignment of the organic compound contained in the photoelectric conversion film 12, the defect of the photoelectric conversion film 12 that the carrier diffusion length is short is compensated and the photoelectric conversion efficiency is enhanced.

When the alignment of the organic compound is controlled, it is more preferred that the heterojunction plane (for example, the pn-junction plane) is not in parallel to the substrate. The heterojunction plane is preferably aligned not in parallel to the substrate (electrode substrate) but at an angle closer to verticality as much as possible. The angle with respect to the substrate is preferably from 10 to 90°, more preferably from 30 to 90°, still more preferably from 50 to 90°, yet still more preferably from 70 to 90°, even yet still more preferably from 80 to 90°, and most preferably 90° (that is, perpendicular to the substrate). The organic compound layer controlled in the heterojunction plane as above may be contained as a part of the entire photoelectric conversion film 12. The ratio of the portion controlled in the alignment to the entire photoelectric conversion film 12 is preferably 10% or more, more preferably 30% or more, still more preferably 50% or more, yet still more preferably 70% or more, even yet still more preferably 90% or more, and most preferably 100%. In such a case, the area of the heterojunction plane in the photoelectric conversion film 12 and in turn the amount of the carrier produced at the interface, such as electron, hole and electron-hole pair, can be increased and the photoelectric conversion efficiency can be enhanced. Particularly, the photoelectric conversion efficiency can be enhanced in the photoelectric conversion film where both the heterojunction plane and the π-electron plane of the organic compound are controlled in the alignment. These conditions are described in detail in Japanese Patent Application No. 2004-079931. The thickness of the organic dye layer is preferably larger in view of light absorption, but considering the proportion not contributing to the electric charge separation, the thickness of the organic dye layer is preferably from 30 to 300 nm, more preferably from 50 to 250 nm, still more preferably from 80 to 200 nm.

In the first invention, the photoelectric conversion film 12 containing the organic compound is formed by a dry film-forming method or a wet film-forming method. Specific examples of the dry film-forming method include a physical vapor growing method such as vacuum vapor deposition, sputtering, ion plating and MBE, and a CVD method such as plasma polymerization. Examples of the wet film-forming method which is used include a casting method, a spin coating method, a dipping method and an LB method. In the second invention, vapor deposition is preferably used as mentioned above.

In the case of using a polymer compound as at least one of the p-type semiconductor (compound) and the n-type semiconductor (compound), the film is preferably formed by a wet film-forming method assured of easy production. In the case of using the dry film-forming method such as vapor deposition, a polymer may decompose and therefore, can be hardly used, but an oligomer may be preferably used instead. On the other hand, in the case of using a low molecular weight compound, the dry film-forming method is preferably employed, and a vacuum vapor deposition method is particularly preferred. In the vacuum vapor deposition method, basic parameters are, for example, the heating method of compound, such as resistance heating vapor deposition and electron beam heating vapor deposition, the shape of vapor deposition source, such as crucible and boat, the degree of vacuum, the vapor deposition temperature, the substrate temperature, and the vapor deposition rate. In order to enable uniform vapor deposition, the vapor deposition is preferably performed while rotating the substrate. The degree of vacuum is preferably higher, and the vacuum vapor deposition is preferably performed at 10⁻⁴ Torr or less, more preferably 10⁻⁶ Torr or less, still more preferably 10⁻⁸ Torr or less. All steps in the vapor deposition are preferably performed in vacuum, and the compound is basically prevented from coming into direct contact with oxygen and water in the outside air. The above-described conditions in the vacuum vapor deposition affect the crystallinity, amorphous property, density, denseness and the like of the organic film and therefore, must be strictly controlled. The PI or PID control of the vapor deposition rate by using a quartz oscillator and a thickness monitor such as interferometer is preferably employed. In the case of simultaneously vapor-depositing two or more kinds of compounds, a co-vapor deposition method, a flash vapor deposition method or the like may be preferably used.

The subbing film 121 is provided, as described above, to suppress an increase of DC short or leak current due to irregularities on the lower electrode 11 surface.

The electron blocking film 122 is provided to reduce the dark current ascribable to injection of an electron from the lower electrode 12 and blocks the injection of an electron into the photoelectric conversion film 12 from the lower electrode 11. The electron blocking film 122 may be formed to serve also as the subbing film 121.

The hole blocking film 124 is provided to reduce the dark current due to injection of a hole from the upper electrode 13 and blocks injection of a hole into the photoelectric conversion film 12 from the upper electrode 13.

The hole blocking and buffer film 125 fulfills a function of reducing the damage given to the photoelectric conversion film 12 at the film formation of the upper electrode 13, as well as the function possessed by the hole blocking film 124. In he case of film-forming the upper electrode 13 as an upper layer of the photoelectric conversion film 12, a high energy particle present in the apparatus used for the film formation of the upper electrode 13, for example, in the case of sputtering, a sputter particle, a secondary electron, an Ar particle, an oxygen negative ion or the like, sometimes bombards the photoelectric conversion film 12 to cause deterioration of the photoelectric conversion film 12 and in turn deterioration in the performance, such as increase of leak current or decrease of sensitivity. As one method for preventing such a problem, a buffer layer 125 is preferably provided as an upper layer of the photoelectric conversion film 12.

As for the material of the hole blocking and buffer film 125, an organic material such as copper phthalocyanine, PTCDA, acetylacetonate complex and BCP, an organic-metal compound, or an inorganic material such as MgAg and MgO is preferably used. Also, the hole blocking and buffer film 125 preferably has a high visible light transmittance so as not to inhibit the light absorption of the photoelectric conversion film 12, and it is preferred to select a material not having absorption in the visible region or use the film in a very small thickness. An appropriate thickness of the hole blocking and buffer film 125 varies, for example, depending on the construction of the photoelectric conversion film 12 or the film thickness of the upper electrode 13, but the hole blocking and buffer film is preferably used in a thickness of 2 to 50 nm.

The work function adjusting film 126 is provided to adjust the work function of the upper electrode 13 and thereby suppress the dark current. In the case where the upper electrode 13 is composed of a material having a relatively large work unction (for example, 4.5 eV or more) (for example, any of ITO, IZO, ZnO₂, SnO₂, TiO₂ and FTO), when a material containing a metal having a work function of 4.5 eV or less (for example, In) is used as the material of the work function adjusting film 126, the dark current can be effectively suppressed. The advantage and the like in providing such a work function adjusting film I26 are described later.

The lower electrode 11 collects a hole by taking it out from the photoelectric conversion film 12 and therefore, is selected by taking into consideration the adhesion or electron affinity to an adjacent film, the ionization potential, the stabiiity and the like. The upper electrode 13 ejects an electron by taking it out from the photoelectric conversion film 12 and therefore, is selected by taking into consideration the adhesion or electron affinity to an adjacent film, the ionization potential, the stability and the like.

In the production of the electrode, various methods are used according to the material. For example, in the case of ITO, the film is formed by a method such as electron beam method, sputtering, resistance heating vapor deposition, chemical reaction (e.g., sol-gel method), and coating of an indium tin oxide dispersion. In the case of ITO, a UV-ozone treatment, a plasma treatment or the like may be applied.

The conditions at the film formation of the electrode film which is transparent (transparent electrode film) are described below. The silicon substrate temperature at the film formation of the transparent electrode film is preferably 500°C or less, more preferably 300°C or less, still more preferably 200°C or less, yet still more preferably 150°C of less. Also, a gas may be introduced during the film formation of the transparent electrode film and the gas species is basically not limited, but Ar, He, oxygen, nitrogen or the like may be used. A mixed gas of these gases may also be used. Particularly, in the case of an oxide material, an oxygen defect is formed in many cases and therefore, oxygen is preferably used.

The preferred range of the surface resistance of the transparent electrode film varies depending on whether the lower electrode 11 or the upper electrode 13. In the case where the signal read-out part has a CMOS structure, the surface resistance of the transparent electrically conductive film is preferably 10,000 Ω/sq. or less, more preferably 1,000 Ω/sq. or less. In the case where the signal read-out part has a CCD structure, the surface resistance is preferably 1,000 Ω/sq. or less, more preferably 100 Ω/sq. or less. In use as the upper electrode 13, the surface resistance is preferably 1,000,000 Ω/sq. or less, more preferably 100,000 Ω/sq. or less.

The upper electrode 13 is preferably produced in a plasma-free state. When the upper electrode 13 is produced in a plasma-free state, the effect of the plasma on the substrate can be reduced and good photoelectric conversion properties can be obtained. Here, the plasma-free state means a state where plasma is not generated during the film formation of the upper electrode 13, or a state where the distance from a plasma source to the substrate is 2 cm or more, preferably 10 cm or more, more preferably 20 cm or more, and the plasma reaching the substrate is decreased.

Examples of the apparatus not generating plasma during the film formation of the upper electrode 13 include an electron beam vapor deposition (EB vapor deposition) apparatus and a pulsed laser vapor deposition apparatus. As for such an EB vapor deposition apparatus or pulsed laser vapor deposition apparatus, apparatuses described, for example, Yutaka Sawada (supervisor), Tomei Doden Maku no Shin Tenkai (New Development of Transparent Conductive Film), CMC (1999), Yutaka Sawada (supervisor), Tomei Doden Maku no Shin Tenkai II (New Development of Transparent Conductive Film II), CMC (2002), Tomei Doden Maku no Gijutsu (Technology of Transparent Conductive Film), JSPS, Ohmsha (1999), and references cited therein may be used. In the following, the method of performing the film formation of the transparent electrode film by using an EB vapor deposition apparatus is referred to as an EB vapor deposition method, and the method of performing the film formation of the transparent electrode by using a pulsed laser vapor deposition apparatus is referred to as a pulsed laser vapor deposition method.

As regards the apparatus capable of realizing a state where the distance from a plasma source to the substrate is 2 cm or more and the plasma reaching the substrate is reduced (hereinafter referred to as a "plasma-free film-forming apparatus"), for example, an opposed-target sputtering apparatus or an arc plasma vapor deposition method is considered, and apparatuses described, for example, in Yutaka Sawada (supervisor), Tomei Doden Maku no Shin Tenkai (New Development of Transparent Conductive Film), CMC (1999), Yutaka Sawada (supervisor), Tomei Doden Makuno Shin Tenkai II (New Development of Transparent Conductive Film II), CMC (2002), Tomei Doden Maku no Gijutsu (Technology of Transparent Conductive Film), JSPS, Ohmsha (1999), and references cited therein may be used.

The material of the transparent electrode film is preferably a material which can be film-formed by a plasma-free film-forming apparatus, an EB vapor deposition apparatus or a pulsed laser vapor deposition apparatus, and suitable examples thereof include a metal, an alloy, a metal oxide, a metal nitride, a metal boride, an organic electrically conductive compound and a mixture thereof. Specific examples thereof include an electrically conductive metal oxide such as tin oxide, zinc oxide, indium oxide, indium zinc oxide (IZO), indium tin oxide (ITO) and indium tungsten oxide (IWO), a metal nitride such as titanium nitride, a metal such as gold, platinum, silver, chromium, nickel and aluminum, a mixture or laminate of such a metal and an electrically conductive metal oxide, an inorganic electrically conductive material such as copper iodide and copper sulfide, an organic electrically conductive material such as polyaniline, polythiophene and polypyrrole, and a laminate thereof with ITO. Also, those described in detail, for example in Yutaka Sawada (supervisor), Tomei Doden Maku no Shin Tenkai (New Development of Transparent Conductive Film), CMC (1999), Yutaka Sawada (supervisor), Tomei Doden Makuno Shin Tenkai II (New Development of Transparent Conductive Film II), CMC (2002), and Tomei Doden Maku no Gijutsu (Technology of Transparent Conductive Film), JSPS, Ohmsha (1999) may be also used.

The advantage in providing the work function adjusting film 126 is described below.

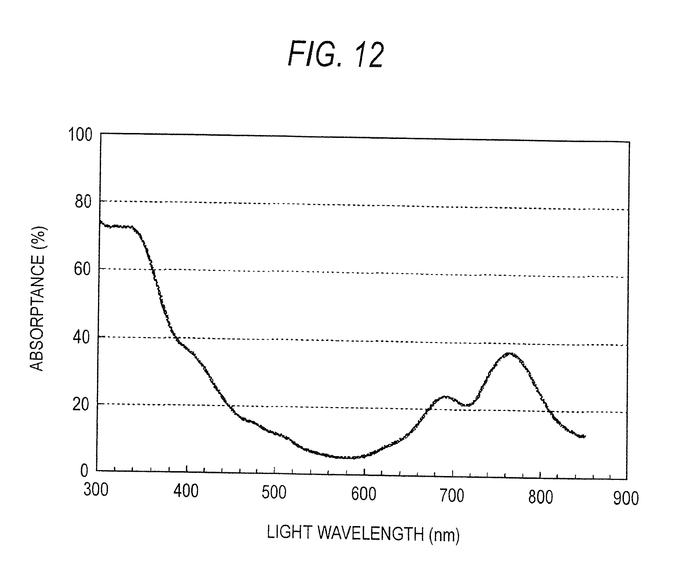

In the case of forming the upper electrode 13 from a material having high work function and high transparency, such as ITO, IZO, ZnO₂, SnO₂, TiO₂ and FTO, the dark current at the bias application to the upper electrode 13 becomes fairly large of about 10 µA/cm² when a voltage of 1 V is applied. One of causes of the dark current is considered to be a current flowing into the photoelectric conversion film from the upper electrode 13 at the bias application. In the case where an electrode having high transparency, such as ITO, IZO, ZnO₂, SnO₂, TiO₂ and FTO, is used as the upper electrode 13, it is considered that the barrier when a hole moves to the photoelectric conversion film 12 becomes low due to the relatively large work function (4.5 eV or more) and injection of a hole into the photoelectric conversion film 12 readily occurs. In practice, when the work function of a metal oxide-based transparent electrode having high transparency, such as ITO, IZO, SnO₂, TiO₂ and FTO, is examined, for example, the work function of the ITO electrode is about 4.8 eV and is fairly high as compared with the work function of an Al (aluminum) electrode, which is about 4.3 eV. Also, metal oxide-based transparent electrodes other than ITO are known to have a relatively large work function of about 4.6 to 5.4, excluding AZO (Al-doped zinc oxide) of which work function is about 4.5 eV and smallest (see, for example, Fig. 12 of J. Vac. Sci. Technol., A17(4), Jul/Aug 1999, pp. 1765-1772).

In the case where the work function of the upper electrode 13 is relatively large (4.8 eV), it is considered that the barrier when a hole moves to the photoelectric conversion film 12 at the bias application becomes low and injection of a hole into the photoelectric conversion film 12 from the upper electrode 13 readily occurs, as a result, a large dark current is formed. In this embodiment, a hole blocking film 124 is provided and therefore, the dark current is suppressed, but if the work function of the upper electrode 13 is large, even when a hole blocking film 124 is provided, it becomes difficult to suppress the dark current.

Accordingly, in this embodiment, a film for making the work function to be 4.5 eV or less is provided between the upper electrode 13 and the photoelectric conversion film 12.

Metals having a work function of 4.5 eV or less are listed below together with the properties thereof

Properties of Metals Having Small Work Function (excluding alkali metal)

| | Work Function (eV) | Melting Point (°C) | Boiling Point (°C) | Bulk Resistivity (Ωcm) | Reaction with Air or Water |
|---|---|---|---|---|---|
| Ag | 4.2 | ○950 | ○2210 | ○1.5×10⁻⁶ | ○ inactive |
| Al | 4.3 | ○660 | ○2470 | ○2.5×10⁻⁶ | Δ oxide film |
| Ba | 2.5 | ○730 | ○1640 | Δ14.6×10⁻⁵ | × oxidized, soluble in water |
| Bi | 4.2 | ○270 | ○1610 | ×1.1×10⁻⁴ | ○ inactive |
| Ca | 2.9 | ○840 | ○1480 | ○3.2×10⁻⁶ | × oxidized, soluble in water |
| Eu | 2.5 | ○820 | ○1600 | Δ9.0×10⁻⁵ | × oxidized, soluble in water |
| Ga | 2.6 | ×28 | ○2400 | Δ1.4×10⁻⁵ | ○ inactive |
| Hf | 3.9 | ○2230 | Δ5200 | Δ3.5×10⁻⁵ | Δ oxide film |
| In | 4.1 | ○160 | ○2080 | ○8.0×10⁻⁶ | ○ inactive |
| La | 3.5 | ○920 | ○3460 | ○5.7×10⁻⁶ | × oxidized, soluble in water |
| Lu | 3.3 | ○1660 | ○3400 | Δ7.9×10⁻⁵ | × oxidized, soluble in water |
| Mg | 3.7 | ○650 | O1090 | ○3.9×10⁻⁶ | × oxidized |
| Mn | 4.1 | ○1240 | ○1960 | ×2.6×10⁻⁴ | × oxidized, soluble in water |
| Nb | 4.3 | ○2470 | Δ4740 | Δ1.3×10⁻⁵ | Δ oxide film |
| Nd | 3.2 | ○1020 | ○3070 | Δ6.4×10⁻⁵ | × soluble in water |
| Pb | 4.2 | ○330 | ○1740 | Δ1.9×10⁻⁵ | × oxidized |
| Sc | 3.5 | ○1540 | ○2830 | Δ6.1×10⁻⁵ | × oxidized, soluble in water |
| Sm | 2.7 | ○1080 | ○1790 | Δ8.8×10⁻⁵ | × soluble in water |
| Sn | 4.5 | ○230 | ○2270 | Δ9.4×10⁻⁵ | ○ inactive |
| Ta | 4.3 | ○3000 | Δ5430 | Δ1.2×10⁻⁵ | ○ inactive |
| Tb | 3.0 | ○1360 | ○3120 | | × oxidized, soluble in water |
| Th | 3.4 | ○1750 | Δ4790 | Δ1.3×10⁻⁵ | × powder ignition |
| Ti | 4.3 | ○1660 | ○3290 | Δ5.8×10⁻⁵ | ○ inactive |
| V | 4.3 | ○1890 | ○3377 | Δ2.5×10⁻⁵ | ○ inactive |
| W | 4.4 | ○3410 | Δ5660 | ○4.9×10⁻⁶ | ○ inactive |
| Y | 3.1 | ○1520 | Δ3340 | Δ5.7×10⁻⁵ | × oxidized |
| Zn | 4.3 | ○420 | Δ910 | ○5.5×10⁻⁶ | × oxidized |
| Zr | 4.1 | ○1850 | Δ4380 | Δ4.0×10⁻⁵ | Δ oxide film |

| | Material | Viewpoint |
|---|---|---|
| Preferred | Ag, Al, Ca, In, Mg | Resistance is small, melting point is not excessively low, and boiling point is not excessively high. Relatively low price. |
| More preferred | Ag, In, Mg | Transparency is high. |
| Most Preferred | Ag, In | Reactivity is low. |

### (Third Embodiment)

In this embodiment, a construction of realizing a solid-state imaging device by using the photoelectric conversion element having the construction shown in Fig. 2B is described.

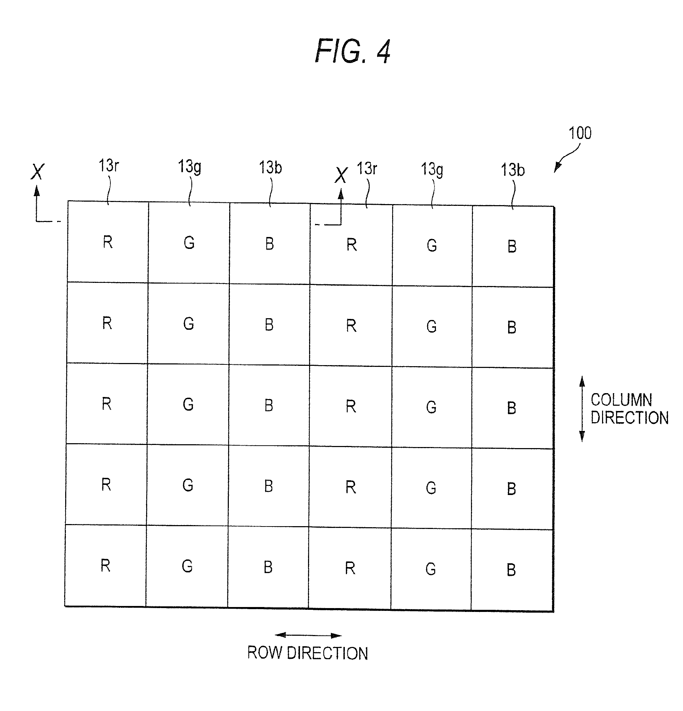

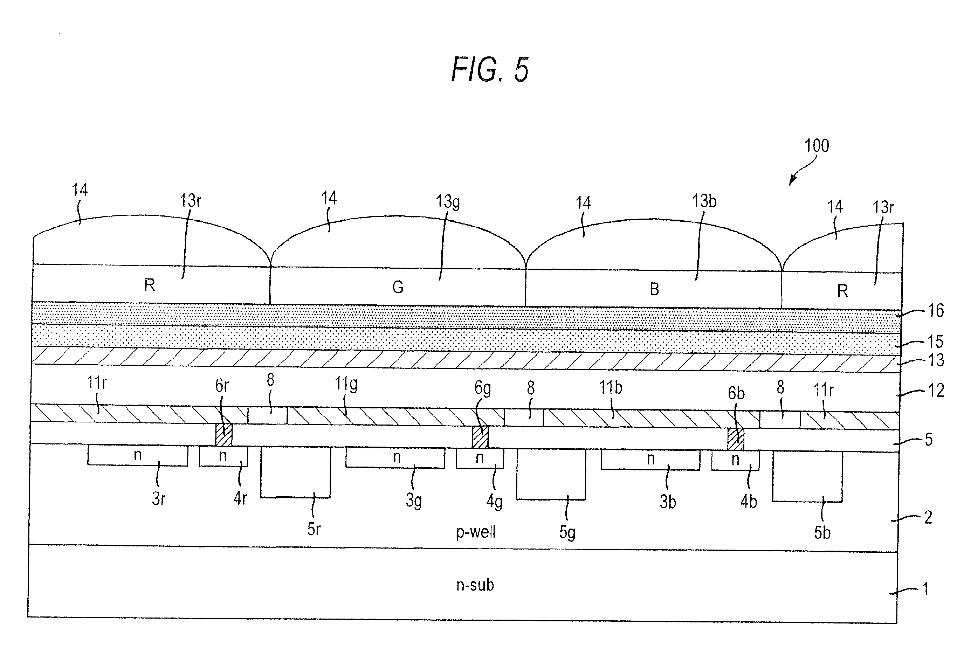

Fig. 4 is a partial surface schematic view of the imaging device for explaining the embodiment of the present invention, and Fig. 5 is a cross-sectional schematic view cut along the A-A line of the imaging device shown in Fig. 4. In Fig. 4, illustration of a microlens 14 is omitted. Also, in Fig. 5, the same constituents as those in Fig. 1 are indicated by the same numerical references.

A p-well layer 2 is formed on an n-type silicon substrate 1. In the following, the n-type silicon substrate 1 and the p-well layer 2 are collectively referred to as a semiconductor substrate. In the row direction and the column direction crossing the row direction at right angles on the same plane above the semiconductor substrate, three kinds of color filters, that is, a color filter 13r mainly transmitting R light, a color filter 13g mainly transmitting G light, and a color filter 13b mainly transmitting B light, each is numerously arrayed.

As for the color filter 13r, the related-art material may be used and such a material transmits a part of infrared light in addition to R light. As for the color filter 13g, the related-art material may be used and such a material transmits a part of infrared light in addition to G light. As for the color filter 13b, the related-art material may be used and such a material transmits a part of infrared light in addition to B light.

For arraying the color filters 13r, 13g and 13b, a color filter array used in the related-art single-plate solid-state imaging devices (e.g., Bayer array, longitudinal stripe, lateral stripe) may be employed.

In the p-well layer 2 on the lower side of the color filter 13r, an n-type impurity region (hereinafter referred to as an "n-region") 3r is formed to correspond to the color filter 13r, and an R photoelectric conversion element (equivalent to the photoelectric conversion part C of Fig. 2B) corresponding to the color filter 13r is constructed by the pn junction of the n-region 3r and the p-well layer 2.

In the p-well layer 2 on the lower side of the color filter 13g, an n-region 3g is formed to correspond to the color filter 13g, and a G photoelectric conversion element (equivalent to the photoelectric conversion part C of Fig. 2B) corresponding to the color filter 13g is constructed by the pn junction of the n-region 3g and the p-well layer 2.

In the p-well layer 2 on the lower side of the color filter 13b, an n-region 3b is formed to correspond to the color filter 13b, and a B photoelectric conversion element (equivalent to the photoelectric conversion part C of Fig. 2B) corresponding to the color filter 13b is constructed by the pn junction of the n-region 3b and the p-well layer 2.

A transparent electrode 11r is formed on the upper side of the n-region 3r, a transparent electrode 11g is formed on the upper side of the n-region 3g, and a transparent electrode 11b is formed on the upper side of the n-region 3b. The transparent electrodes 11r, 11g and 11b are divided to correspond to the color filters 13r, 13g and 13b, respectively. The transparent electrodes 11r, 11g and 11b each has the same function as the lower electrode 11 of Fig. 1.

A photoelectric conversion film 12 in one-sheet construction shared in common among the color filters 13r, 13g and 13b is formed on the transparent electrodes 11r, 11g and 11b.

An upper electrode 13 in one-sheet construction shared in common among the color filters 13r, 13g and 13b is formed on the photoelectric conversion film 12.

A photoelectric conversion element (equivalent to the photoelectric conversion part A of Fig. 2B) corresponding to the color filter 13r is formed by the transparent electrode 11r, the upper electrode 13 facing it, and a part of the photoelectric conversion film 12 sandwiched therebetween. This photoelectric conversion element is hereinafter referred to as an on-substrate R photoelectric conversion element, because it is formed on the semiconductor substrate.

A photoelectric conversion element (equivalent to the photoelectric conversion part A of Fig. 2B) corresponding to the color filter 13g is formed by the transparent electrode 11g, the upper electrode 13 facing it, and a part of the photoelectric conversion film 12 sandwiched therebetween. This photoelectric conversion element is hereinafter referred to as an on-substrate G photoelectric conversion element.

A photoelectric conversion element (equivalent to the photoelectric conversion part A of Fig. 2B) corresponding to the color filter 13b is formed by the transparent electrode 11b, the upper electrode 13 facing it, and a part of the photoelectric conversion film 12 sandwiched therebetween. This photoelectric conversion element is hereinafter referred to as an on-substrate B photoelectric conversion element.

A high-concentration n-type impurity region (hereinafter referred to as an "n+region") 4r for accumulating an electric charge generated in the photoelectric conversion film 12 of the on-substrate R photoelectric conversion element is formed in adjacency to the n-region 3r within the p-well layer 2. Incidentally, a light-shielding film is preferably provided on the n+region 4r for preventing light from entering the n+region 4r.

An n+region 4g for accumulating an electric charge generated in the photoelectric conversion film 12 of the on-substrate G photoelectric conversion element is formed in adjacency to the n-region 3g within the p-well layer 2. Incidentally, a light-shielding film is preferably provided on the n+region 4g for preventing light from entering the n+region 4g.

An n+region 4b for accumulating an electric charge generated in the photoelectric conversion film 12 of the on-substrate B photoelectric conversion element is formed in adjacency to the n-region 3b within the p-well layer 2. Incidentally, a light-shielding film is preferably provided on the n+region 4b for preventing light from entering the n+region 4b.

A contact part 6r comprising a metal such as aluminum is formed on the n+region 4r, the transparent electrode 11r is formed on the contact part 6r, and the n+region 4r and the transparent electrode 11r are electrically connected by the contact part 6r. The contact part 6r is embedded in an insulating layer 5 transparent to visible light and infrared light.

A contact part 6g comprising a metal such as aluminum is formed on the n+region 4g, the transparent electrode 11g is formed on the contact part 6g, and the n+region 4g and the transparent electrode 11g are electrically connected by the contact part 6g. The contact part 6g is embedded in the insulating layer 5.

A contact part 6b comprising a metal such as aluminum is formed on the n+region 4b, the transparent electrode 11b is formed on the contact part 6b, and the n+region 4b and the transparent electrode 11b are electrically connected by the contact part 6b. The contact part 6b is embedded in the insulating layer 5.

In the other region within the p-well layer 2, where the n-regions 3r, 3g and 3b and the n+regions 4r, 4g and 4b are not formed, a signal read-out part 5r for reading out each of a signal according to the electric charge generated in the R photoelectric conversion element and accumulated in the n-region 3r and a signal according to the electric charge accumulated in the n+region 4r, a signal read-out part 5g for reading out each of a signal according to the electric charge generated in the G photoelectric conversion element and accumulated in the n-region 3g and a signal according to the electric charge accumulated in the n+region 4g, and a signal read-out part 5b for reading out each of a signal according to the electric charge generated in the B photoelectric conversion element and accumulated in the n-region 3b and a signal according to the electric charge accumulated in the n+region 4b are formed. For each of the signal read-out parts 5r, 5g and 5b, the related-art construction using a CCD or MOS circuit may be employed. Incidentally, a light-shielding film is preferably provided on each of the signal read-out parts 5r, 5g and 5b for preventing light from entering the signal read-out parts 5r, 5g and 5b.

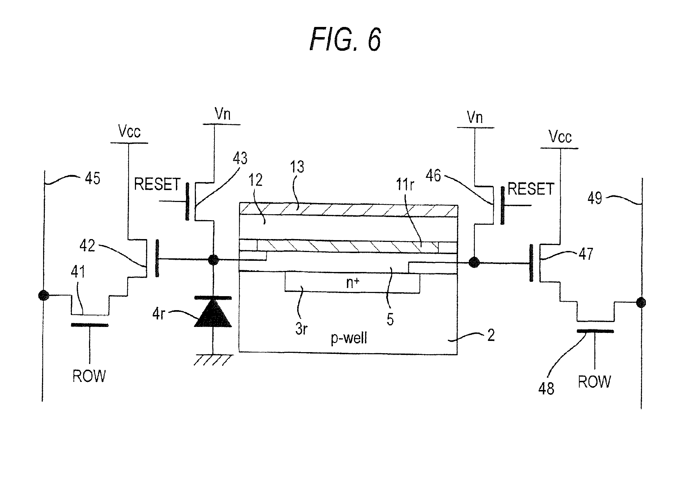

Fig. 6 is a view showing a specific construction example of the signal read-out part 5r shown in Fig. 5. In Fig. 6, the same constituents as those in Figs. 4 and 5 are indicated by the same numerical references. Incidentally, the signal read-out parts 5r, 5g and 5b have the same construction and the description of the signal read-out parts 5g and 5b is omitted.

The signal read-out part 5r comprises a reset transistor 43 with a drain being connected to the n+region 4r and a source being connected to a power source Vn, an output transistor 42 with a gate being connected to the drain of the reset transistor 43 and a source being connected to a power source Vcc, a row selection transistor 41 with a source being connected to the drain of the output transistor 42 and a drain being connected to a signal output line 45, a reset transistor 46 with a source being connected to the n-region 3r and a source being connected to a power source Vn, an output transistor 47 with a gate being connected to the drain of the reset transistor 46 and a source being connected to a power source Vcc, and a row selection transistor 48 with a source being connected to the drain of the output transistor 47 and a drain being connected to a signal output line 49.

When a bias voltage is applied between the transparent electrode 11r and the upper electrode 13, an electric charge is generated according to light entered the photoelectric conversion film 12 and the electric charge moves to the n+region 4r through the transparent electrode 11r. The electric charge accumulated in the n+region 4r is converted by the output transistor 42 into a signal according to the electric charge amount. When the row selection transistor 41 is turned ON, the signal is output to the signal output line 45. After the output of the signal, the electric charge in the n+region 4r is reset by the reset transistor 43.

The electric charge generated in the R photoelectric conversion element and accumulated in the n-region 3r is converted by the output transistor 47 into a signal according to the electric charge amount. When the row selection transistor 48 is turned ON, the signal is output to the signal output line 49. After the output of the signal, the electric charge in the n-region 3r is reset by the reset transistor 46.

In this way, the signal read-out part 5r can be constructed by the related-art MOS circuit comprising three transistors.

Backing to Fig. 5, protective layers 15 and 16 each having a two-layer structure are formed on the photoelectric conversion film 12 for protecting the photoelectric conversion elements on the substrate. The color filters 13r, 13g and 13b are formed on the protective layer 16, and a microlens 14 is formed on each of the color filters 13r, 13g and 13b for condensing light on each of the corresponding n-regions 3r, 3g and 3b.

This imaging device 100 is produced by forming the photoelectric conversion film 12 and then forming the color filters 13r, 13g and 13b, the microlens 14 and the like, but the formation of the color filters 13r, 13g and 13b or the microlens 14 involves a photolithography step and a bake step and in the case of using an organic material as the photoelectric conversion film 12, when the photolithography step or bake step is performed in the state of the photoelectric conversion film 12 being exposed, this causes deterioration in the properties of the photoelectric conversion film 12. In the imaging device 100, the protective films 15 and 16 are provided for preventing the properties of the photoelectric conversion film 12 from deterioration ascribable to such a production process.

The protective layer 15 is preferably an inorganic layer comprising an inorganic material and being formed by an ALCVD method. The ALCVD method is an atomic layer CVD method and enables the formation of a dense inorganic layer, and the layer formed can be an effective protective layer of the photoelectric conversion layer 9. The ALCVD method is also known as an ALE method or an ALD method. The inorganic layer formed by the ALCVD method preferably comprises Al₂O₃, SiO₂, TiO₂, ZrO₂, MgO, HfO₂ or Ta₂O₅, more preferably Al₂O₃ or SiO₂, and most preferably Al₂O₃.

The protective layer 16 is formed on the protective layer 15 for more enhancing the performance of protecting the photoelectric conversion film 12 and is preferably an organic layer comprising an organic polymer. The organic polymer is preferably parylene, more preferably parylene C. Incidentally, the protective layer 16 may be omitted, or the arrangement of the protective layer 15 and the protective layer 16 may be reversed. Particularly, a high effect of protecting the photoelectric conversion film 12 is obtained by the construction shown in Fig. 5.

In the imaging device 100 having the above-described construction, of the light transmitted through the color filter 13r out of the incident light, light in the infrared region is absorbed in the photoelectric conversion film 12, and an electric charge according to the infrared light is generated here. Similarly, of the light transmitted through the color filter 13g out of the incident light, light in the infrared region is absorbed in the photoelectric conversion film 12, and an electric charge according to the infrared light is generated here. Also, similarly, of the light transmitted through the color filter 13b out of the incident light, light in the infrared region is absorbed in the photoelectric conversion film 12, and an electric charge according to the infrared light is generated here.

When a predetermined bias voltage is applied to the transparent electrode 11r and the upper electrode 13, the electric charge generated in the photoelectric conversion film 12 constituting the on-substrate R photoelectric conversion element moves to the n+region 4r through the transparent electrode 11r and the contact part 6r and is accumulated here. A signal according to the electric charge accumulated in the n+region 4r is read out by the signal read-out part 5r and output outside the imaging device 100.

Similarly, when a predetermined bias voltage is applied to the transparent electrode 11g and the upper electrode 13, the electric charge generated in the photoelectric conversion film 12 constituting the on-substrate G photoelectric conversion element moves to the n+region 4g through the transparent electrode 11g and the contact part 6g and is accumulated here. A signal according to the electric charge accumulated in the n+region 4g is read out by the signal read-out part 5g and output outside the imaging device 100.

Also, similarly, when a predetermined bias voltage is applied to the transparent electrode 11b and the upper electrode 13, the electric charge generated in the photoelectric conversion film 12 constituting the on-substrate B photoelectric conversion element moves to the n+region 4b through the transparent electrode 11b and the contact part 6b and is accumulated here. A signal according to the electric charge accumulated in the n+region 4b is read out by the signal read-out part 5b and output outside the imaging device 100. Furthermore, R light transmitted through the color filter 13r and transmitted through the photoelectric conversion film 12 enters the R photoelectric conversion element, and an electric charge according to the incident light quantity is accumulated in the n-region 3r. Similarly, G light transmitted through the color filter 13g and transmitted through the photoelectric conversion film 12 enters the G photoelectric conversion element, and an electric charge according to the incident light quantity is accumulated in the n-region 3g. Also, similarly, B light transmitted through the color filter 13b and transmitted through the photoelectric conversion film 12 enters the B photoelectric conversion element, and an electric charge according to the incident light quantity is accumulated in the n-region 3b. The electric charges accumulated in the n-regions 3r, 3g and 3b are read out by the signal read-out parts 5r, 5g and 5b and output outside the imaging device 100.

The array of signals read out and output from the n-regions 3r, 3g and 3b becomes the same as the array of signals output from a single-plate color solid-state imaging device having a color filter array shown in Fig. 4 and therefore, by performing the signal processing used in a single-plate color solid-state imaging device, color image data where one pixel data have the data of R, G and B three color components can be produced. Also, infrared image data where one pixel data have the infrared color component data can be produced using the signals read out and output from the n+regions 4r, 4g and 4b.

In this way, the imaging device 100 can output to the exterior the signal of R component according to the electric charge generated in the R photoelectric conversion element, the signal of G component according to the electric charge generated in the G photoelectric conversion element, the signal of B component according to the electric charge generated in the B photoelectric conversion element, the signal of IR component according to the electric charge generated in the photoelectric conversion element on the R substrate, the signal of IR component according to the electric charge generated in the photoelectric conversion element on the G substrate, and the signal of IR component according to the electric charge generated in the photoelectric conversion element on the B substrate. Therefore, when the imaging device 100 is used, two kinds of image data, that is, color image data and infrared image data, can be obtained by one imaging operation. Accordingly, this imaging device 100 can be utilized as an imaging device of an endoscope requiring an external image of an inspection-target site of a human body as well as an internal image of the site.

### [Example]

### [Example 1]

Amorphous ITO was film-formed to a thickness of 30 nm on a silicon substrate by a sputtering method to form a lower electrode, and Compound 1 represented by the chemical formula shown below was film-formed to a thickness of 100 nm on the lower electrode by a vacuum heating vapor deposition method to form an electron blocking film. Subsequently, copper phthalocyanine and Alq represented by the chemical formula shown below were vapor-deposited in combination to a total thickness of 70 nm by a vacuum heating vapor deposition method to form a photoelectric conversion film. At this time, the ratio between the vapor deposition speeds of copper phthalocyanine and Alq was set to be 1:1. Furthermore, Alq was film-formed to a thickness of 15 nm on the photoelectric conversion film by a vacuum heating vapor deposition method to form a hole blocking film, and amorphous ITO was then film-formed to a thickness of 5 nm on the hole blocking film by a sputtering method to form an upper electrode. In this way, a photoelectric conversion element was produced.

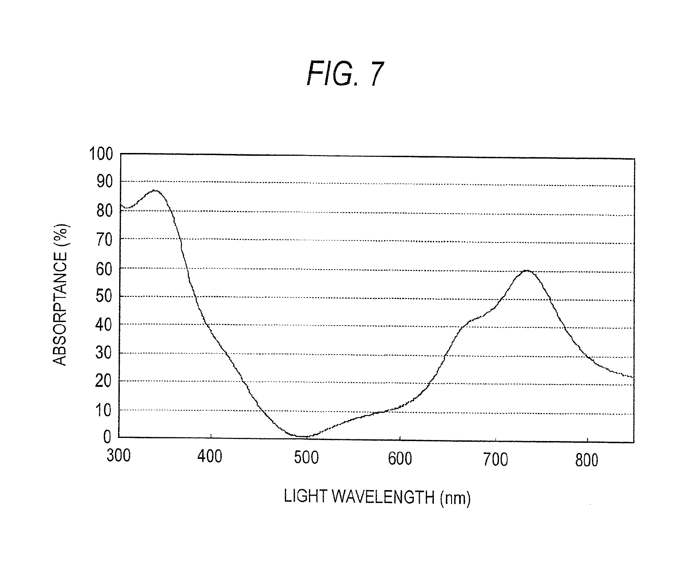

Fig. 7 shows the measurement results of the absorption spectrum of the photoelectric conversion part comprising an ITO lower electrode, an electron blocking film, a photoelectric conversion film, a hole blocking film and an ITO upper electrode. As seen in Fig. 7, in the photoelectric conversion part of this Example, the absorptance of visible light was about 40% or less, and the absorptance of infrared light at a wavelength of 680 to 780 nm was 40% or more (the maximum absorption was at about 740 nm). This reveals that when the lower and upper electrodes each is composed of ITO and the photoelectric conversion film is composed of copper phthalocyanine, a photoelectric conversion part transmitting as a whole about 50% or more of visible light can be produced.

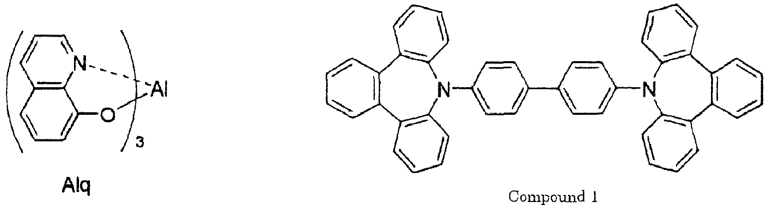

### [Example 2-1]

### (Synthesis of Squarylium Compound 3)

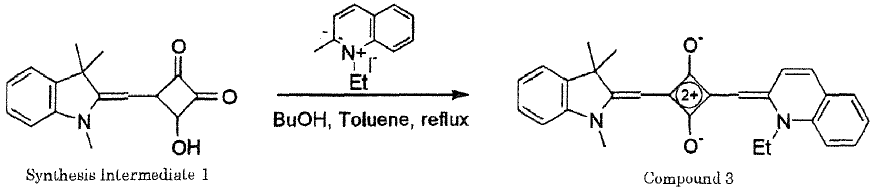

Synthesis Intermediate 1 (1.43 g, 5.0 mmol) synthesized according to the literature (Dyes and Pigments, 21, 227-234 (1993)) and 1-ethyl-2-methylquinolinium iodide (1.50 g, 5.0 mmol) were mixed with 1-butanol (30 mL) and toluene (30 mL), and the mixture was refluxed under heating for about 6 hours. After cooling to room temperature, the precipitate was suction-filtered and washed with isopropanol to obtain a green powder. This powder was boiled in chloroform and after suction filtration and washing, further boiled in acetone, followed by suction filtration and washing, whereby Compound 3 (1.6 g, yield: 74%) was obtained as a green powder.

¹H NMR (DMSO, 300 MHz) δ = 9.43 (d, 1H), 8.04 (d, 1H), 7.95 (d, 1H), 7.85 (d, 1H), 7.77 (t, 1H), 7.50 (t, 1H), 7.42 (d, 1H), 7.28 (t, 1H), 7.17 (d, 1H), 7.04 (t, 1H), 5.90 (s, 1H), 5.53 (s, 1H), 4.54 (q, 2H), 3.43 (s, 3H), 1.66 (s, 6H), 1.43 (t, 3H).

### [Example 2-2]

### (Synthesis of Squarylium Compound 2)

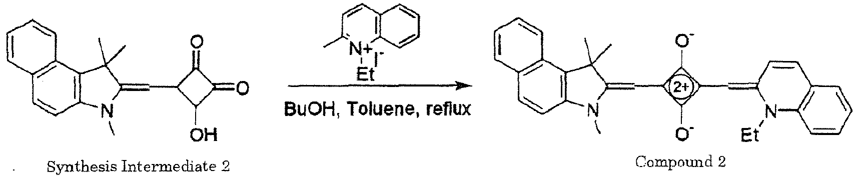

Squarylium Compound 2 was synthesized by the same operation as in Example 2-1 except that Synthesis Intermediate 2 synthesized by the same method was used in place of Synthesis Intermediate 1 in Example 2-1.

¹H NMR (CDCl₃, 300 MHz) δ = 9.53 (d, 1H), 8.18 (d, 1H), 7.89-7.83 (m, 2H), 7.67-7.49 (m, 5H), 7.40-7.32 (2H), 7.30-7.24 (m, 1H), 6.01 (s, 1H), 5.82 (s, 1H), 4.43 (q, 2H), 3.57 (s, 3H), 2.08 (s, 6H), 1.56 (t, 3H).

### [Example 2-3]

### (Example of Photoelectric Conversion Element)

Amorphous ITO was film-formed to a thickness of 30 nm on a silicon substrate by a sputtering method to form a lower electrode, Compound 1 shown by the chemical formula above was then film-formed to a thickness of 100 nm on the lower electrode by vacuum heating vapor deposition, and Compound 2 shown by the chemical formula below was further film-formed thereon to a thickness of 50 nm by vacuum heating vapor deposition to form a photoelectric conversion film. Subsequently, Alq shown by the chemical formula above was film-formed to a thickness of 50 nm on the film above by vacuum heating vapor deposition to form a hole blocking film, and amorphous ITO was then film-formed to a thickness of 5 nm on the hole blocking film by a sputtering method to form an upper electrode. In this way, a photoelectric conversion element was produced.

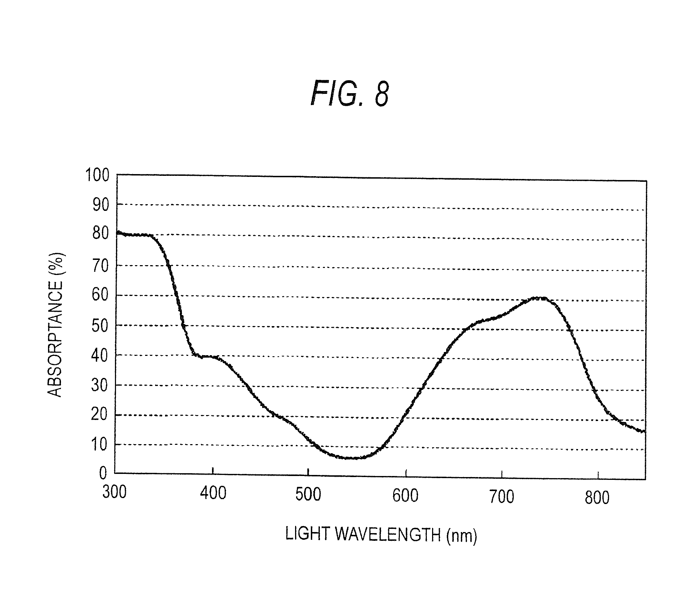

The vacuum heating vapor deposition operations above all were performed at a vacuum degree of 4×10⁻⁴ Pa or less. The transmittance in the wavelength region of 400 to 900 nm of the upper electrode itself was 98% or more. Fig. 8 shows the measurement results of the absorption spectrum of the photoelectric conversion part comprising an ITO lower electrode, a photoelectric conversion film, a hole blocking film and an ITO upper electrode. During the vapor deposition of Compound 2, decomposition of the material was not generated. In the absorption spectrum, maximum absorption was present at 738 nm, and the absorptance at 450 to 600 nm was 30% or less.

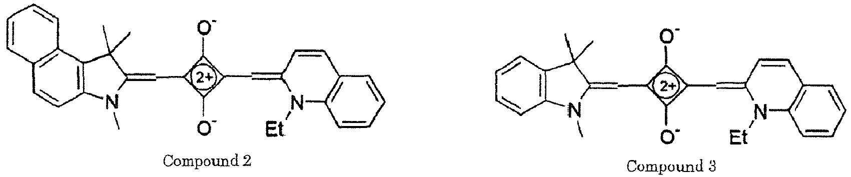

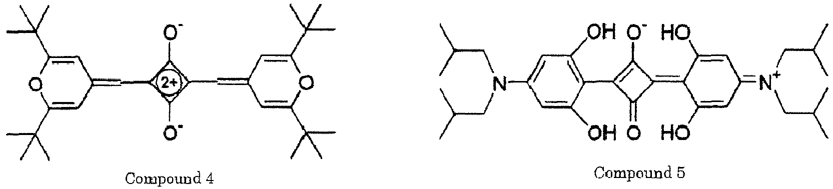

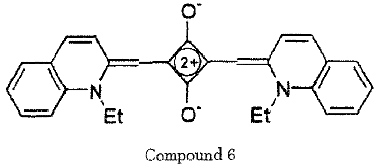

### [Example 2-4]

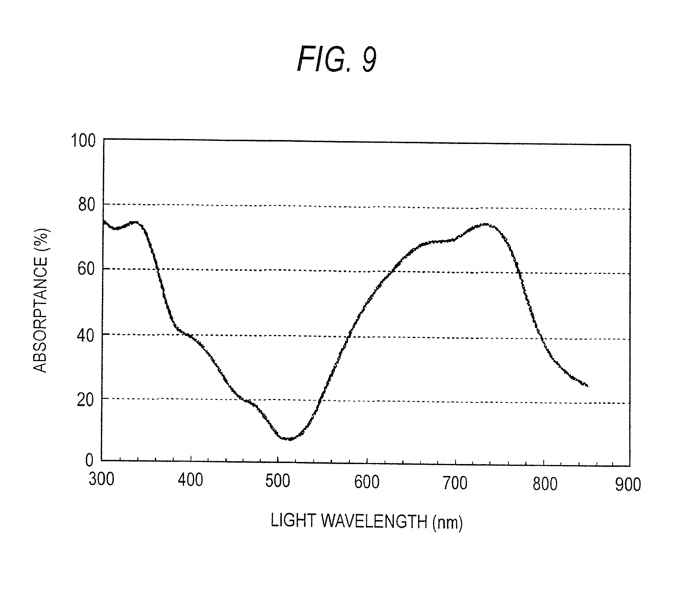

A photoelectric conversion element was produced in the same manner as in Example 2-3 except for changing Compound 2 of the photoelectric conversion film to Compound 3. The transmittance in the wavelength region of 400 to 900 nm of the upper transparent electrode itself was 98% or more. Fig. 9 shows the measurement results of the absorption spectrum of the photoelectric conversion part comprising an ITO lower electrode, a photoelectric conversion film, a hole blocking film and an ITO upper electrode. During the vapor deposition of Compound 3, decomposition of the material was not generated. In the absorption spectrum, maximum absorption was present at 733 nm, and the absorptance at 450 to 600 nm was 50% or less.

### [Reference Example 1]

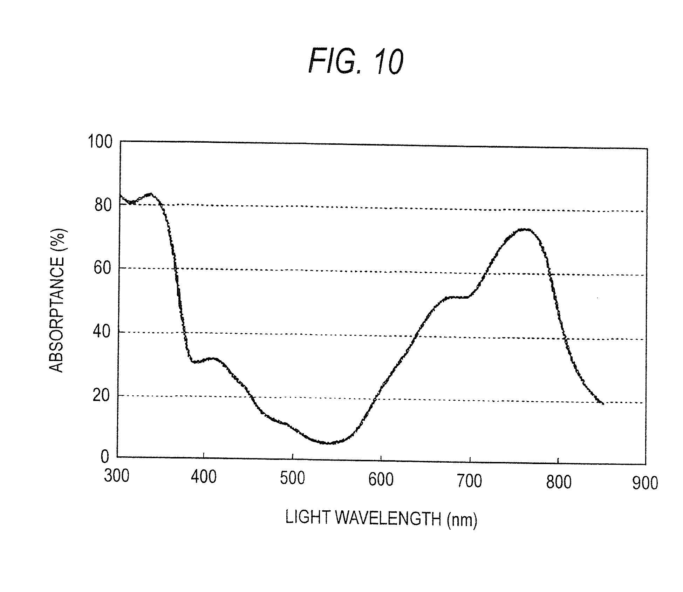

A photoelectric conversion element was produced in the same manner as in Example 2-3 except for changing Compound 2 of the photoelectric conversion film to Compound 4. The transmittance in the wavelength region of 400 to 900 nm of the upper transparent electrode itself was 98% or more. Fig. 10 shows the measurement results of the absorption spectrum of the photoelectric conversion part comprising an ITO lower electrode, a photoelectric conversion film, a hole blocking film and an ITO upper electrode. During the vapor deposition of Compound 4, decomposition of the material was not generated. In the absorption spectrum, maximum absorption was present at 760 nm, and the absorptance at 450 to 600 nm was 30% or less.

### [Comparative Example 1]

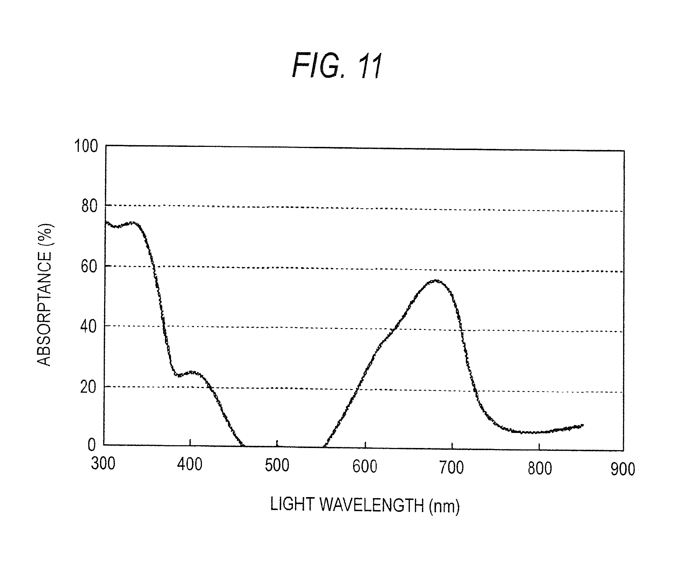

A photoelectric conversion element was produced in the same manner as in Example 2-3 except for changing Compound 2 of the photoelectric conversion film to Compound 5. The transmittance in the wavelength region of 400 to 900 nm of the upper transparent electrode itself was 98% or more. Fig. 11 shows the measurement results of the absorption spectrum of the photoelectric conversion part comprising an ITO lower electrode, a photoelectric conversion film, a hole blocking film and an ITO upper electrode. During the vapor deposition of Compound 5, decomposition of the material was not generated. In the absorption spectrum, maximum absorption was present at 680 nm, and the absorptance at 450 to 600 nm was 30% or less.

### [Comparative Example 2]

A photoelectric conversion element was produced in the same manner as in Example 2-3 except for changing Compound 2 of the photoelectric conversion film to Compound 6. The transmittance in the wavelength region of 400 to 900 nm of the upper transparent electrode itself was 98% or more. Fig. 12 shows the measurement results of the absorption spectrum of the photoelectric conversion part comprising an ITO lower electrode, a photoelectric conversion film, a hole blocking film and an ITO upper electrode. During the vapor deposition of Compound 6, decomposition of the material was not generated. In the absorption spectrum, maximum absorption was present at 765 nm, and the absorptance at 450 to 600 nm was 30% or less.

Regarding Compounds 2 to 6 in Examples 2-3 and 2-4, Reference Example 1 and Comparative Examples 1 and 2, the vapor deposition temperature, the decomposition temperature measured by TG-DTA in nitrogen, and the external quantum efficiency at the maximum sensitivity wavelength with a dark current of 3 nA/Cm² of each photoelectric conversion element are shown in Table A. Incidentally, in the measurement of the photoelectric conversion performance of each element, an appropriate voltage was applied.

**Table A**

| | Compound Used for Light Absorption to Photoelectric Conversion | Decomposition During Vapor Deposition of Compound | Decomposition Temperature (°C) of Compound by TG-DTA Measurement in N₂ | Vapor Deposition Temperature (°C) of Compound | External Quantum Efficiency at Maximum Sensitivity Wavelength with Dark Current of 3 nA/cm² (relative value) |
|---|---|---|---|---|---|
| Example 2-3 | compound 2 | none | 283 | 263 | 74 |
| Example 2-4 | compound 3 | none | 277 | 243 | 100 |
| Reference Example 1 | compound 4 | none | 223 | 188 | 3 |
| Comparative Example 1 | compound 5 | none | 256 | 160 | 48 |
| Comparative Example 2 | compound 6 | decomposed | 260 | 255 | 4 |

When an inappropriate material is selected as in Comparative Example 2, the difference between the vapor deposition temperature and the decomposition temperature becomes small, decomposition occurs during vapor deposition, and the photoelectric conversion efficiency is low. In Reference Example 1 and Comparative Example 1, a vapor deposition film can be obtained, for example, by imparting a bulky substituent, thereby increasing the difference between the decomposition temperature and the vapor deposition temperature and suppressing the decomposition during vapor deposition, but the photoelectric conversion efficiency in the low dark current region decreases. In contrast, with Compounds 1 and 2 which are the squarylium compound of the present invention, not only a different large enough to hold the vapor deposition property is obtained between the vapor deposition temperature and the decomposition temperature but also a high photoelectric conversion performance can be obtained in a low dark current region. According to the present invention, it is possible to detect the visible light by PD in the substrate and imaging the infrared light at 700 nm or more by the upper photoelectric conversion part at the same time on the same point with high S/N.

The entire disclosure of each and every foreign patent application from which the benefit of foreign priority has been claimed in the present application is incorporated herein by reference, as if fully set forth.

## Claims

1. An element, which is a photoelectric conversion element comprising a first photoelectric conversion part comprising:
(i) a pair of electrodes and, between the pair of electrodes, and
(ii) between the pair of electrodes, a photoelectric conversion film comprising an organic photoelectric conversion material comprising a compound of the formula (SQ-2) : 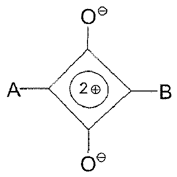 wherein
A is a group of the formula 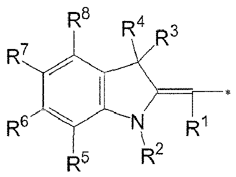 wherein R¹-R⁸ each independently represents H or a substituent, and a plurality of groups among R¹-R⁸ may combine to form a ring, and * indicates the bonding position to the cyclobutane ring; and
B is a substituent with a bonding site being an sp² carbon.

2. The element of claim 1, wherein formula (SQ-2) is represented by formula (SQ-3):

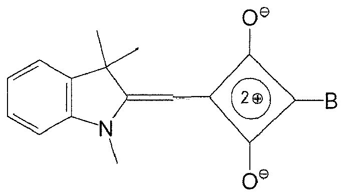

3. The element of claim 1, wherein B is the same as A or a portion corresponding to A, and the compound has a decomposition temperature of ≥ 200°C.

4. The element of claim 1, wherein
- the organic photoelectric conversion material has an absorption peak in the wavelength range of 680-10,000 nm and generating an electric charge according to light absorbed, and
- the first photoelectric conversion part as a whole transmits ≥ 50% of light in the wavelength range of 400-650 nm.

5. The element of claim 4, wherein an absorption peak wavelength of the photoelectric conversion film is ≥ 650 nm, and the first photoelectric conversion part as a whole transmits ≥ 75% of visible light.

6. The element of claim 4, wherein the absorptance at the absorption peak wavelength of the photoelectric conversion film is ≥ 50%.

7. The element of claim 4, wherein the light transmittance in the wavelength range of 400-10,000 nm of one, on a light incident side, of the pair of electrodes is ≥ 95%.

8. The element of claim 4, wherein the light transmittance in the wavelength range of 400-650 nm of one, on a side opposite to a light incident side, of the pair of electrodes is ≥ 95%.

9. The element of claim 4, wherein the pair of electrodes each comprises TCO.

10. The element of claim 9, wherein the TCO is ITO.

11. The element of claim 4, further comprising:
(iii) a semiconductor substrate being below the first photoelectric conversion part; and
(iv) between the semiconductor substrate and the first photoelectric conversion part, at least one visible light photoelectric conversion part having an absorption peak in the wavelength range of 400-650 nm and generating an electric charge according to light absorbed.

12. The element of claim 11, wherein the semiconductor substrate comprises:
- an accumulation part that accumulates an electric charge generated in each of the first photoelectric conversion part and the at least one visible light photoelectric conversion part; and
- a signal read-out part that reads out a signal according to the electric charge accumulated in the accumulation part.

13. The element of claim 4, further comprising:
(iii) a semiconductor substrate being below the first photoelectric conversion part; and
(v) in the semiconductor substrate, at least one visible light photoelectric conversion part having an absorption peak in the wavelength range of 400-650 nm and generating an electric charge according to light absorbed.

14. The element of claim 13, wherein the semiconductor substrate comprises:
- an accumulation part that accumulates an electric charge generated in the first photoelectric conversion part; and
- a signal read-out part that reads out a signal according to the electric charge accumulated in the accumulation part.

15. The element of claim 11, which comprises a plurality of visible light photoelectric conversion parts having an absorption peak at wavelengths different from each other.

16. The element of claim 15, wherein the plurality of visible light photoelectric conversion parts are stacked in a light incident direction to the first photoelectric conversion part.

17. The element of claim 14, which comprises a plurality of visible light photoelectric conversion parts which have an absorption peak at wavelengths different from each other and are arrayed in a vertical direction with respect to a light incident direction to the first photoelectric conversion part.

18. The element of claim 11, which comprises three visible light photoelectric conversion parts which are
- an R photoelectric conversion part that absorbs light in the red wavelength region,
- a G photoelectric conversion part that absorbs light in the green wavelength region, and
- a B photoelectric conversion part that absorbs light in the blue wavelength region.

19. The element of claim 1, wherein the first photoelectric conversion part and said at least one visible light photoelectric conversion part are overlapped as viewed in plane such that light transmitted through the first photoelectric conversion part enters said at least one visible light photoelectric conversion part.

20. The element of claim 1, wherein the photoelectric conversion film comprises a hole blocking layer and an electron blocking layer.

21. A solid-state imaging device comprising, disposed on the same plane in an array manner, photoelectric conversion elements each of which is the photoelectric conversion element claimed in claim 1.

22. A squarylium compound of the formula (SQ-3): 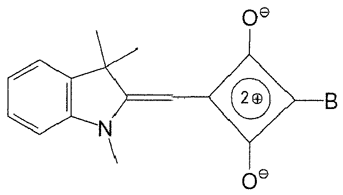 wherein B is a substituent which has a sp² carbon bonding site and comprises a quinoline nucleus, a pyrylium nucleus, a thiopyrylium nucleus, an azulene nucleus or a dihydroperimidine nucleus.
